(19) Europäisches Patentamt
European Patent Office
Office européen des brevets

(11) EP 3 577 523 B1

(12) **EUROPÄISCHE PATENTSCHRIFT**

(45) Veröffentlichungstag und Bekanntmachung des Hinweises auf die Patenterteilung:
**13.01.2021 Patentblatt 2021/02**

(21) Anmeldenummer: **18702464.1**

(22) Anmeldetag: **26.01.2018**

(51) Int Cl.:
***G03F 7/038*** *(2006.01)*

(86) Internationale Anmeldenummer:
**PCT/EP2018/051949**

(87) Internationale Veröffentlichungsnummer:
**WO 2018/141644 (09.08.2018 Gazette 2018/32)**

(54) **STRAHLUNGSHÄRTBARES GEMISCH ENTHALTEND NIEDRIG FUNKTIONALISIERTES TEILVERSEIFTES POLYVINYLACETAT**

RADIATION-CURABLE COMPOSITION CONTAINING LOW FUNCTIONALIZED PARTIALLY SAPONIFIED POLYVINYL ACETATE

MÉLANGE DURCISSANT SOULS L’ACTION D’UN RAYONNEMENT COMPRENANT UN POLYACÉTATE DE VINYLE SEMI-DURCI FAIBLEMENT FONCTIONNALISÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.01.2017 EP 17153935**

(43) Veröffentlichungstag der Anmeldung:
**11.12.2019 Patentblatt 2019/50**

(73) Patentinhaber: **Flint Group Germany GmbH**
**70469 Stuttgart (DE)**

(72) Erfinder:
- **PIETSCH, Christian**
**77654 Offenburg (DE)**
- **BECKER, Armin**
**67259 Großniedesheim (DE)**
- **KRAUSS, Uwe**
**76857 Gossersweiler-Stein (DE)**
- **TELSER, Thomas**
**69123 Heidelberg-Wieblingen (DE)**

(74) Vertreter: **Arnold & Siedsma**
**Bezuidenhoutseweg 57**
**2594 AC The Hague (NL)**

(56) Entgegenhaltungen:
**EP-A1- 0 962 828**
**EP-A2- 0 079 514**
**AT-B- 326 920**
**DE-A1- 19 933 139**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

**Beschreibung**

Die vorliegende Erfindung betrifft ein strahlungshärtbares Gemisch, das als wesentliche Bestandteile mindestens ein wasserlösliches oder in Wasser dispergierbares funktionalisiertes teilverseiftes Polyvinylacetat, mindestens einen Photopolymerisationsinitiator, eine oder mehrere mit dem teilverseiften Polyvinylacetat verträgliche, ethylenisch ungesättigte, photopolymerisierbare niedermolekulare Verbindungen sowie weitere Zusatzstoffe enthält. Sie betrifft außerdem strahlungshärtbare Mehrschichtelemente enthaltend das strahlungsempfindliche Gemisch sowie deren Verwendung.

Die Herstellung einer Reliefstruktur wird im Allgemeinen durch folgende Schritte erreicht: Ein strahlungshärtbares Gemisch wird in fließfähiger Form auf einen formstabilen Träger aufgebracht, verfestigt und bildmäßig (durch Verwendung einer Maske oder durch Beschreiben mit einem Lichtstrahl) belichtet. Durch die Belichtung werden die belichteten Bereiche vernetzt und dadurch unlöslich oder unschmelzbar. In einem nachfolgenden Entwicklungsschritt werden die nicht belichteten, nicht gehärteten Bereiche entfernt und so eine Reliefstruktur erzeugt. Im Fall von teilverseiften Polyvinylacetaten wird die Entfernung der unbelichteten Bereiche durch Auswaschen mit Wasser oder einem wässrigen Auswaschmittel erzielt. Anschließend wird in der Regel noch ein Trocknungsschritt durchgeführt.

Die Herstellung teilverseifter funktionalisierter Polyvinylacetate ist bekannt und beispielsweise in USRE2740, DE 3015419, EP 0079514, DE 3322993, DE 3322994, EP 849635 und EP 962828 beschrieben. Strahlungshärtbare Gemische und daraus erzeugte Reliefstrukturen sind ebenfalls bekannt und beispielsweise in DE 3015419, EP 0079514, DE 3322993, DE 3322994, EP 849635 und EP962828 beschrieben. DE3015419 beschreibt die Verwendung von funktionalisierten teilverseiften Polyvinylacetaten in einer haftungsverbessernden Zwischenschicht zwischen Substrat und strahlungsempfindlicher Schicht. EP 0079514 zeigt die Verwendung von funktionalisierten teilverseiften Polyvinylacetaten, die durch einen Überschuss an Funktionalisierungsmittel erhalten wurden, in Reliefstrukturen mit dem Ziel, die Stabilität bei der Trocknung zu verbessern. DE 3322993 und DE 3322994 beschreiben ein verbessertes Herstellungsverfahren für funktionalisierte teilverseiften Polyvinylacetate durch den Einsatz von Katalysatoren und die Verwendung der funktionalisierten teilverseiften Polyvinylacetate zur Erzeugung von Reliefstrukturen. EP 849635 beschreibt ein strahlungshärtbares Gemisch umfassend zwei verschiedene Bindemittel, wovon eines ein funktionalisiertes teilverseiftes Polyvinylacetat mit hohem Funktionalisierungsgrad ist. EP 962828 beschreibt eine weitere Verbesserung der Synthese von funktionalisierten teilverseiften Polyvinylacetaten und deren Verwendung in strahlungshärtbaren Gemischen zur Erzeugung von Reliefstrukturen.

Die beschriebenen Reliefstrukturen weisen jedoch Defizite auf. Als verbesserungswürdige Eigenschaften sind das Curling, die geringe Reißdehnung und die geringe Elastizität der Reliefstrukturen zu nennen. Das Curling äußert sich darin, dass sich die Reliefstrukturen einige Zeit nach der Entwicklung von den Rändern her in Richtung der vom Substrat abgewandten Seite aufzurollen beginnen, was eine weitere Verwendung, insbesondere die Montage auf einen Druckzylinder, erschwert und zur Bildung von Rissen führen kann.

Aufgabe der Erfindung ist es, strahlungshärtbare Gemische mit reduziertem Curling der daraus erhaltenen Reliefstrukturen bereitzustellen. Aufgabe der Erfindung ist es insbesondere, solche Gemische mit erhöhter Reißdehnung und Elastizität der daraus erzeugten Reliefstrukturen bereitzustellen. Dabei sollen vorzugsweise die Belichtungszeiten der strahlungshärtbaren Gemische und die Auswaschzeiten bei der Entwicklung der Reliefstrukturen gleich bleiben oder sogar verkürzt werden. Eine weitere Aufgabe der Erfindung ist es, Reliefstrukturen zu erzeugen, die niedrige Rastertonwerte (Hochlichter) besser halten und im Druck abbilden.

Es hat sich nun gezeigt, dass das Curling der Reliefstrukturen deutlich reduziert und deren mechanischen Eigenschaften verbessert werden können, wenn in dem strahlungshärtbaren Gemisch funktionalisierte teilverseifte Vinylacetatpolymere mit einem niedrigen Anteil (< 3 mol-%) an Vinylacrylat-Einheiten eingesetzt werden.

Gelöst wird die Aufgabe somit durch ein strahlungshärtbares Gemisch zur Erzeugung von Reliefstrukturen enthaltend

a) mindestens ein funktionalisiertes teilverseiftes Polyvinylacetat enthaltend (i) Vinylalkohol-, (ii) Vinylacetat- und (iii) Vinylacrylat-Einheiten,
wobei die Vinylacrylat-Einheiten substituiert sein können und die allgemeine Struktur

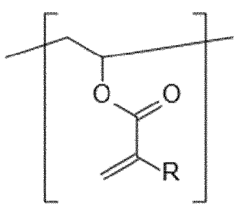

aufweisen, wobei R Wasserstoff oder ein linearer oder verzweigter aliphatischer oder heteroaliphatischer Rest mit 1 bis 12 C-Atomen oder ein cycloaliphatischer, heterocyclischer oder aromatischer Rest mit 3 bis 12 C-Atomen ist, als Komponente A,

b) mindestens einen Initiator als Komponente B,

c) mindestens eine von Komponente A verschiedene ethylenisch ungesättigte Verbindung als Komponente C,

d) optional ein oder mehrere Zusatzstoffe als Komponente D,

wobei der Gehalt an Vinylacrylat-Einheiten (iii) des funktionalisierten teilverseiftes Polyvinylacetats a), bezogen auf alle Einheiten (i), (ii) und (iii), 0,1 bis < 3 mol-% beträgt und die Komponente D ein zu Wasserstoffbrückenbildung fähiges Additiv in einer Menge von 1 bis 30 Gew.-%, bezogen auf die Summe der Komponenten A bis D, enthält.

Bevorzugte aliphatische Reste R sind lineares oder verzweigtes, gegebenenfalls mit mindestens einer Halogen-, Hydroxy-, Mercapto-, Ether-, Amin-, Carbonsäure-, Ester-, Urethan-, Aldehyd-, Nitro-, $CF_3$- oder Cyanogruppe, substituiertes $C_1$-$C_{12}$-Alkyl, besonders bevorzugt gegebenenfalls substituiertes $C_1$-$C_4$-Alkyl, wie Methyl, Ethyl, Propyl, iso-Propyl, Butyl, iso-Butyl, sec-Butyl, tert-Butyl oder N-Acetyl, $CH_2$-Br, insbesondere Methyl, Ethyl und $CH_2$-COOH, speziell Methyl.

Bevorzugte cycloaliphatische Reste gegebenenfalls mit einer Halogen-, Hydroxy-, Mercapto-, Ether-, Amin-, Carbonsäure-, Ester-, Urethan-, Aldehyd-, Nitro-, $CF_3$- oder Cyanogruppe sind Cyclohexyl-, Cyclopentyl-, Cyclobutyl-, Cyclopropyl-, Cyclopentadien-, Decalin-, Adamantan- und Campher- Reste.

Bevorzugte heterocyclische Reste, gegebenenfalls mit einer Halogen-, Hydroxy-, Mercapto-, Ether-, Amin-, Carbonsäure-, Ester-, Urethan-, Aldehyd-, Nitro-, $CF_3$- oder Cyanogruppe, sind 2-Pyrrolidin-, Tetrahydrofuran- , Tetrahydrothiopen-, Pyran-, tTiopyran-, Pyrazol-, Imidazol-, Piperidine- und Morpholin Reste.

Bevorzugte aromatische bzw. heteroaromatische Reste gegebenenfalls mit einer Halogen-, Hydroxy-, Mercapto-, Ether-, Amin-, Carbonsäure-, Ester-, Urethan-, Aldehyd-, Nitro-, $CF_3$- oder Cyanogruppe sind
Phenyl-, Benzyl-, Pyridin-, Naphthyl-, Pyrrol-, Furan-, Thiophen-, Pyridin-, Pyrazol-, Benzinidazol-, Indol-, Isochinolin-, Purin, Pyrimidin-, Oxazol- Thiazol- Reste.

Die Vinylalkohol-, Vinylacetat- und Vinylacrylat-Einheiten liegen selbstverständlich in dem Polymer in einpolymerisierter Form vor. Der Anteil der Vinylmonomer-Einheiten wird in mol-%, bezogen auf alle Vinylalkohol-, Vinylacetat- und gegebenenfalls substituierte Vinylacrylat-Einheiten des Polymers angegeben. Der Anteil der gegebenenfalls substituierten Vinylacrylat-Einheiten beträgt dabei im Allgemeinen 0,2 bis < 3 mol-%, beispielsweise 0,2 bis 2,9 mol-%, bevorzugt 0,5 bis < 3 mol-%, beispielsweise 0,5 bis 2,9 mol-%, besonders bevorzugt 1 bis < 3 mol-%, beispielsweise 1 bis 2,9 mol-%, ganz besonders bevorzugt 1 bis 2,5 mol-%, aber auch bevorzugt 0,1 bis 2,5 mol-% oder 0,2 bis 2,5 mol-% oder 0,5 bis 2,5 mol-%.

Insbesondere bevorzugte gegebenenfalls substituierte Vinylacrylat-Einheiten sind Vinylacrylat, Vinylmethacrylat, Vinyl-2-ethylacrylat, Vinyl-2-propylacrylat, Vinyl-2-butylacrylat und Vinylitaconsäure (R = $CH_2$-COOH). Speziell bevorzugt sind Vinylacrylat (R = H) und Vinylmethacrylat
(R = $CH_3$), abgekürzt als Vinyl(meth)acrylat.

Der Gehalt an Vinylalkoholeinheiten in dem Polymer beträgt im Allgemeinen 65 bis 95 mol-%, bevorzugt 70 bis 90 mol-% und besonders bevorzugt 80 bis 85 mol-%, bezogen auf alle Einheiten.

Der Gehalt von Vinylacetateinheiten in dem Polymer beträgt im Allgemeinen 5 bis 35 mol-%, besonders bevorzugt 10 bis 30 mol-% und insbesondere bevorzugt 10 bis 20 mol-% und speziell bevorzugt im Bereich von 15-20 mol-%, bezogen auf alle Einheiten.

Im Allgemeinen beträgt das Verhältnis der Vinylalkoholeinheiten zu den gegebenenfalls substituierten Vinylacrylateinheiten 20 : 1 bis 400 : 1, bevorzugt 10 : 1 bis 100 : 1, besonders bevorzugt 25 : 1 bis 85 : 1. Im Allgemeinen beträgt das Verhältnis der Vinylacetateinheiten zu den gegebenenfalls substituierten Vinylacrylateinheiten 5 : 1 bis 50 : 1, bevorzugt 5 : 1 bis 30 : 1 und besonders bevorzugt 5 : 1 bis 20 : 1.

Die in dem strahlungshärtbaren Gemisch enthaltenen funktionalisierten teilverseiften Polyvinylacetate weisen im Allgemeinen eine bei einer Temperatur von 20°C und als 4%ige wässrige Lösung mittels Kugelfallviskosimeter gemessene Viskosität im Bereich von 0,5 mPas bis 250 mPas auf. Vorzugsweise beträgt die Viskosität 2 mPas bis 50 mPas, besonders bevorzugt 2 mPas bis 40 mPas.

Im Allgemeinen enthält das strahlungshärtbare Gemisch die funktionalisierten teilverseiften Polyvinylacetate in einer Menge von 5 bis 75 Gew.-%, bevorzugt 5 bis 60 Gew.-%, besonders bevorzugt 5 bis 50 Gew.-%, bezogen auf die Summe aller Komponenten A bis D des strahlungshärtbaren Gemischs.

Das strahlungshärtbare Gemisch enthält weiterhin als Komponente B einen oder mehrere Polymerisationsinitiatoren. Geeignet sind Initiatoren oder Initiatorsysteme aus mindestens 2 Komponenten, die bei Bestrahlung mit elektromagnetischen Wellen Radikale erzeugen, die eine Polymerisation und/oder Vernetzung bewirken. Derartige Initiatoren sind dem Fachmann bekannt und beispielsweise in folgender Literatur beschrieben: Bruce M. Monroe et al., Chemical Review, 93, 435 (1993), R. S. Davidson, Journal of Photochemistry and Biology A: Chemistry, 73, 81 (1993), J. P. Faussier, Photoinitiated Polymerization-Theory and Applications: Rapra Review, Vol. 9, Report, RapraTechnology

(1998), M. Tsunooka et al., 25 Prog. Polym. Sci., 21, 1 (1996), F. D. Saeva, Topics in Current Chemistry, 1 56, 59 (1990), G. G. Maslak, Topics in Current Chemistry, 168, 1 (1993), H. B. Shuster et al., JAGS, 112, 6329 (1990) and I. D. F. Eaton et al., JAGS, 102, 3298 (1980), P. Fouassier and J. F. Rabek, Radiation Curing in Polymer Science and Technology, pages 77 to 117 (1993) or K.K. Dietliker, Photoinitiators for free Radical and Cationic Polymerisation, Chemistry & Technology of UV & EB Formulation for Coatings, Inks and Paints, Volume, 3, Sita Technology LTD, London 1991; or R.S. Davidson, Exploring the Science, Technology and Applications of U.V. and E.B. Curing, Sita Technology LTD, London 1999. Weitere Initiatoren sind beschrieben in JP45-37377, JP44-86516, US3567453, US4343891, EP109772, EP109773, JP63138345, JP63142345, JP63142346, JP63143537, JP4642363, JP59152396, JP61151197, JP6341484, JP2249 and JP24705, JP626223, JPB6314340, JP1559174831, JP1304453 und JP1152109.

Bevorzugt sind Initiatoren oder Initiatorsysteme aus mindestens 2 Komponenten, die aus der Gruppe der allgemein als Norrish Typ I oder Norrisch Typ II Initiatoren stammen, denen eine H-Abstraktion oder Elektronenübertragung zugrunde liegt. Zu den Norrish Typ I Initiatoren gehören beispielsweise benzoylradikalbildenden Initiatoren, $\alpha$-Hydroxyketone, $\alpha$-Aminoketone, Acylphosphinoxide, Bisacylphosphinoxide, Triazine und Hexaarylbisimidazole, die zusätzlich mit Farbstoffen oder Sensibilisatoren kombiniert werden können, um die Empfindlichkeit zu erhöhen. Bei den Norrish Typ II Initiatoren sind insbesondere Kombinationen von Ketonen oder Aldehyden mit H-Überträgern wie beispielsweise Aminen oder Thiolen zu nennen. Bevorzugt sind die Initiatoren ausgewählt aus der Gruppe bestehend aus Benzildimethylketal, Diphenyl(2,4,6-trimethylbenzoyl)phosphine oxide, 2, 4, 6-trimethylbenzoylphenyl phosphinate; Bis(2,4,6-trimethylbenzoyl)-phenylphosphineoxide, Bis(2,6-Dimethoxybenzoyl)- 2,-1,4-trimethylpentyl) phosphine oxide, Michler's Keton, Benzophenon alleine und/oder kombiniert mit Sensibilisatoren, Aminen oder Thiolen und beliebige Kombinationen davon. Weitere einsetzbare Initiatoren stellen Oniumsalze, organische Peroxide, Thioverbindungen, Ketoxime, Borate, Azinium- und Azoverbindungen, Metallocene und Verbindungen mit eine Kohlenstoff-Halogen Gruppe dar, die ebenfalls kombiniert oder zusammen mit Sensibilisatoren, Aminen oder Thiolen eingesetzt werden können. Bei den Sensibilisatoren sind beispielsweise Xanthone, Thioxanthone, Anthracene, Perylene, Phenothiazine, Benzophenone, Acetophenone und Farbstoffe einsetzbar. Voraussetzung für eine Sensibilisierung ist dabei, dass entweder die Triplettenergie des Sensibilisators höher ist als die des zu sensibilisierenden Initiators oder es zu einer Elektronenübertragung aus einem angeregten Zustand des Sensibilisators kommen kann.

Die Wellenlänge der eingestrahlten elektromagnetischen Strahlung liegt dabei im Bereich von 200 bis 2000 nm, bevorzugt im UV-Bereich, besonders bevorzugt im Bereich von 250 bis 550 nm, ganz besonders bevorzugt im Bereich von 300 bis 450 nm. Neben breitbandiger Einstrahlung der elektromagnetischen Wellen kann es vorteilhaft sein schmalbandige oder monochromatische Wellenlängenbereiche zu verwenden, wie sie unter Einsatz von entsprechenden Filtern, Lasern oder Light Emitting Diodes (LEDs) erzeugt werden können. In diesen Fällen sind Wellenlängen in den Bereichen 350, 365, 385, 395, 400, 405, 532, 830, 1064 nm einzeln (und ca. 5-10 nm darüber und/oder darunter) oder als Kombinationen bevorzugt.

Die Initiatoren oder Initiatorkombinationen weisen in diesen Wellenlängenbereichen mindestens ein Absorptionsmaximum auf, wobei die Lage des Absorptionsmaximums nicht mit dem Emissionsmaximum der elektromagnetischen Strahlung übereinstimmen muss, es ist jedoch vorteilhaft, wenn beide sich möglichst stark überlappen.

Im Allgemeinen enthält das strahlungshärtbare Gemisch den Initiator oder das Initiatorsystem in Mengen von 0,1 bis 20 Gew.-% bezogen auf die gesamte Formulierung. Bevorzugt beträgt die Initiator-Konzentration 0,1 bis 10 Gew.-%, besonders bevorzugt 0,1 bis 5 Gew.-%, ganz besonders bevorzugt 0,5 bis 5 Gew.-%, bezogen auf die Summe aller Komponenten A bis D.

Als Komponente C enthält das strahlungshärtbare Gemisch von Komponente A verschiedene, niedermolekulare ethylenisch ungesättigte Verbindung mit mindestens einer ethylenisch ungesättigten Gruppe. Als ethylenisch ungesättigte Verbindungen kommen solche in Betracht, die mit dem polymeren Bindemitteln der Komponente A verträglich sind. Bevorzugt enthält die ethylenisch ungesättigte Verbindung mindesten 2 ethylenisch ungesättigte Gruppen, besonders bevorzugt 2 bis 6 ethylenisch ungesättigte Gruppen, ganz besonders bevorzugt genau 2 ethylenisch ungesättigte Gruppen. Auch Verbindungen mit C-C Dreifachbindungen können in dem strahlungshärtbaren Gemisch eingesetzt werden. Vorzugsweise handelt es sich bei der mindestens einen ethylenisch ungesättigten Gruppe um eine Acrylat- und/oder eine Methacrylatgruppe, es können jedoch auch Acrylamide, Vinylether oder Styrol-Derivate als ethylenisch ungesättigte Verbindungen zum Einsatz kommen. Die ethylenisch ungesättigte Verbindung kann ein monomere, oligomere oder polymere ethylenisch ungesättigte Verbindung sein und eine linearer, verzweigte, sternförmiger oder dendritischer Struktur aufweisen. Die niedermolekularen ethylenisch ungesättigten Verbindungen der Komponente C weisen ein Molekulargewicht von kleiner 5000 g/mol auf. Bevorzugt ist das Molekulargewicht kleiner als 3000 g/mol, besonders bevorzugt kleiner als 1000 g/mol, ganz besonders bevorzugt kleiner als 500 g/mol und kann auch kleiner als 300 g/mol sein. Im Allgemeinen beträgt das Molekulargewicht der niedermolekularen ethylenisch ungesättigten Verbindungen mindestens 86.

Bevorzugt sind Derivate der Acryl- und/oder Methacrylsäure, wie deren Ester mit ein- oder mehrwertigen Alkoholen, beispielsweise Acryl- oder Methacrylsäureester von Alkanolen mit 1 bis 20 Kohlenstoffatomen, wie Methylmethacrylat, Ethylacrylat, Propyl(meth)acrylat, Isopropyl-(meth)acrylat, n-Butyl(meth)acrylat, Isobutyl(meth)acrylat,

tert.-Butyl(meth)acrylat, Hexyl(meth)acrylat, Cyclohexyl(meth)acrylat, 2-Ethylhexyl(meth)acrylat, Lauryl(meth)acrylat, (Meth)acrylester mehrwertiger Alkohole mit 2 bis 20 Kohlenstoffatomen, z.B. 2-Hydroxyethyl(meth)acrylat, 2-Hydroxypropyl(meth)acrylat, Ethylenglykoldi(meth)acrylat, Polyethylenglykoldi(meth)acrylat, Butandiol-1,4-di(meth)acrylat, Neopentylglykoldi(meth)acrylat, 3-Methylpentandioldi(meth)acrylat, 1,1,1-Trimethylolpropantri(meth)acrylat, 1,4-Butandioldiacrylat, 1,6-Hexandioldiacrylat, 1,6-Hexandioldimethacrylat, 1,9-Nonandioldiacrylat, Di-, Tri- und Tetraethylenglykoldi(meth)acrylat, Tripropylenglykoldi(meth)acrylat oder Pentaerythrittetra(meth)acrylat, des weiteren Poly(ethylenoxid)di(meth)acrylat, m-Methylpoly(ethylenoxid)-yl-(meth)acrylat, N,N-Diethylaminoethylacrylat, ein Umsetzungsprodukt aus 1 Mol Glycerin, 1 Mol Epichlorhydrin und 3 Mol Acrylsäure sowie Glycidylmethacrylat und Bisphenol-A-diglycidetheracrylat. (Meth)acrylsäurederivate mit Carbonsäure- und/oder Amino-Gruppen.

Ebenso eignen sich Derivate des Acrylamids und des Methacrylamids, wie z.B. Ether ihrer N-Methylolderivate mit ein- und mehrwertigen Alkoholen, z.B. Ethylenglykol, Glycerin, 1,1,1-Trimethylolpropan, oligomeren oder polymeren Ethylenoxidderivaten. Diese eignen sich besonders, wenn Polyamide oder Polyvinylalkohol als Bindemittel eingesetzt werden.

Geeignet sind auch sogenannte Epoxid- und Urethan(meth)acrylate, wie sie beispielsweise durch Umsetzung von Bisphenol-A-diglycidylether mit (Meth)acrylsäure oder durch Umsetzung von Diisocyanaten mit Hydroxyalkyl(meth)acrylaten oder mit hydroxylgruppenhaltigen Polyestern oder Polyethern erhalten werden können. Weiterhin einsetzbare olefinisch ungesättigte Verbindungen sind Ester der Acryl- oder Methacrylsäure, insbesondere solche mit niedrigem Dampfdruck und solche, die mit Verträglichkeitsvermittlern modifiziert sind, z.B. mit Hydroxy-, Amido-, Sulfoester- oder Sulfonamidgruppen. Auch Gemische der obengenannten copolymerisierbaren ethylenisch ungesättigten organischen Verbindungen können eingesetzt werden.

Bevorzugt ethylenisch ungesättigte niedermolekulare Verbindungen sind Phenylglycidyletheracrylat, Glycerindimethacrylat, 1,4-Butanediylbis[oxy(2-hydroxy-3,1-propandiyl)]diacrylat, 2-Hydroxyethylmethacrylat, 2,3-Epoxypropylmethacrylat, Ethyldiglycolacrylat, Hydroxypropylacrylat, Butandioldiacrylat, Triethylenglykoldiacrylat, Bisphenol A-diglycidyletherdiacrylat, 2-(Dimethylamino)ethylmethacrylat, tert-Butylaminoethylmethacrylat, tert-Butylacrylat, Polyethylenglykolmethacrylat, Benzylacrylat, Tetrahydrofurfurylacrylat, Phenoxymethylmethacrylat, Vinylpyrrolidon und Vinylacetat sowie die entsprechenden Methacrylate.

Besonders bevorzugt sind Phenylglycidyletheracrylat Glycerindiacrylat, 1,4-Butanediylbis[oxy(2-hydroxy-3,1-propandiyl)]diacrylat, Ethylendiacrylat, 2-Hydroxyethylmethacrylat, Butandioldiacrylat, Hexandioldiacrylat sowie die entsprechenden Methacrylat.

In einer Ausführungsform enthält die Komponente C Phenylglycidyletheracrylat.

Im Allgemeinen ist die ethylenisch ungesättigte Verbindung in Mengen von 0,5 bis 50 Gew.-%, bevorzugt von 1 bis 40 Gew.-%, besonders bevorzugt von 5 bis 40 Gew.-%, ganz besonders bevorzugt im Bereich von 10 bis 40 Gew.-%, bezogen auf die Summe der Komponenten A bis D der Formulierung, enthalten.

Das Strahlungshärtbare Gemisch enthält einen oder mehrere Zusatzstoffe, ausgewählt aus der Gruppe bestehend aus Weichmachern, Lösungsmitteln, weiteren polymeren Bindemitteln, farbgebenden Mitteln, Stabilisatoren (Inhibitoren), Reglern , UV-Absorbern, Dispergierhilfsmitteln, organischen oder anorganischen Füllstoffen, weiteren, nichtradikalischen Vernetzern, Viskositätsveränderern und Wasserstoffbrücken akzeptierenden Additiven. Diese Zusatzstoffe sind in den strahlungshärtbaren Gemischen in einer Gesamtmenge im Bereich von 1 bis 50 Gew.-%, bezogen auf die gesamte Formulierung, enthalten. Bevorzugt sind sie insgesamt in Mengen von 1 bis 40 Gew.-%, besonders bevorzugt 1 bis 30 Gew.-% und ganz besonders bevorzugt von 1 bis 20 Gew.-%, bezogen auf die Summe der Komponenten A bis D, enthalten. Die einzelnen Additive sind dabei in Konzentrationen von 0,001 bis 30 Gew.-%, bevorzugt im Bereich von 0,001 bis 20 Gew.-%, besonders bevorzugt im Bereich von 0,001 bis 10 Gew.-% und ganz besonders bevorzugt im Bereich von 0,001 bis 5 Gew.-%, bezogen auf die gesamte Formulierung, enthalten.

In einer Ausführungsform können Weichmacher, wie beispielsweise Polyethylenglykole, Glycerin, Ethylenglykol, N-Alkyl-benzolsulfonamide, Phthalate und beliebige Mischungen davon, in dem strahlungshärtbaren Gemisch enthalten sein. Geeignete Weichmacher sind beispielsweise aliphthalische Säureester, z.B. Dimethylphthalat, Diethylphthalat, Dibutylphthalat, Diisobutylphthalat, Diocylphthalat, Octylcaprylphthalat, Dicyclohexylphthalat, Ditridecylphthalate, Butylbenzylphthalat, Diisodecylphthalate oder Diallylphthalate; Glykolester, z.B. Dimethylglykolphthalate, Ethylphthalylethylglykolat, Methylphthalylethylglykolat, Butylphthalylbutylglykolat oder Triethyleneglycoldicaprylisäureester; Phosphorsäure-Ester z.B. Tricresylphosphat oder Triphenylphosphat; aliphatische Diester, z.B. Diisobutyladipat, Dioctyladipat, Dimethylsebacetat, Dibutylsebacetat, Dioctylazelat oder Dibutylmaleat; Pentaerythritolpolyoxyethylenether; Polyglycidylmethacrylat; Triethylcitrat; Glycerintriacetylester und Butyllaurat. Der Weichmachergehalt beträgt im Allgemeinen 1 bis 30 Gew.-%, bevorzugt 1 bis 20 Gew.-%, besonders bevorzugt 1 bis 10 Gew.-% und ganz besonders bevorzugt 3 bis 10 Gew.-%, bezogen auf das Gewicht der gesamten Formulierung.

Als weitere, von Komponente A verschiedene Bindemittel kommen vollständig oder teilweise verseifte Polyvinylester, z.B. teilverseifte Polyvinylacetate, Polyvinylalkoholderivate, wie teilverseiftes Vinylacetat/Alkylenoxid-Pfropfmischpolymerisat, sowie deren Gemische in Frage. Ebenso eignen sich als polymere Bindemittel in Wasser oder Wasser/Alkohol-Mischungen lösliche Polyamide, wie sie beispielsweise in EP 0 085 472 oder in DE 1522444 beschrieben

sind. Die Konzentration der weiteren Bindemittel liegt dabei, sofern sie enthalten sind, im Allgemeinen im Bereich von 1 bis 50 Gew.-%,bevorzugt im Bereich von 1 bis 40 Gew.-%, besonders bevorzugt im Bereich von 1 bis 35 Gew.-% und ganz besonders bevorzugt im Bereich von 1 bis 30 Gew.-%, bezogen auf die gesamte Formulierung, enthalten.

Weiterhin können Inhibitoren gegen die thermische Polymerisation, die keine nennenswerte Eigenabsorption in dem aktinischen Bereich, in dem der Photoinitiator absorbiert, aufweisen, zugesetzt werden, wie z.B. 2, 6-Di-tert.-butyl-p-kresol, Hydrochinon, p-Methoxyphenol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze des N-Nitrosocyclohexylhydroxylamins. Weitere geeignete Inhibitioren uns Stabilisatoren sind beispielsweise in A. Valet, Lichtschutzmittel für Lacke, 33ff, Vincentz Verlag Hannover 1996 beschrieben. Besonders bevorzugt sind sterisch gehinderte Phenole und Amine.

Als farbgebende Mittel können Farbstoffe, Pigmente oder photochrome Zusatze dem strahlungshärtbaren Gemisch in einer Menge von 0,0001 bis 2 Gew.-%, bezogen auf das Gemisch, zugesetzt sein. Sie dienen der Steuerung der Belichtungseigenschaften, als Regler, der Identifizierung, der direkten Kontrolle des Belichtungsergebnisses oder ästhetischen Zwecken. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, das Salz bzw. Amid aus Rhodamin D (Basic Violet 10, C.I. 45170), Methylenblau B (C.I. 52015), Thioninblau G (C.I. 52025), Acriflavin (C.I. 46000), Acridinorange (C.I. 46005) oder Solvent Black 3 (C.I. 26150). Diese Farbstoffe können auch zusammen mit einem Reduktionsmittel verwendet werden, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff insbesondere N-Allylthioharnstoff, sowie Hydroxylaminderivate, insbesondere Salze des N-Nitrosocyclohexylhydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel können im Allgemeinen in Mengen von 0,005 bis 5 Gew.-%, bezogen auf das Gemisch zugesetzt werden, wobei sich in vielen Fällen der Zusatz eines 3- bis 10-fachen der Menge an mitverwendetem Farbstoff bewährt hat.

Als Regler sind beispielsweise Hydroxylaminderivate, insbesondere Salze des N-Nitrosocyclohexylhydroxylamins, vorzugsweise die Kalium-, Calcium- und Aluminiumsalze oder -SH enthaltende Verbindungen wie Mercaptoethanol, Mercaptopropanol, Thiophenol, Thioglycerin, Thioglykolsäureethylester, Thioglykolsäuremethylester, Dodecylmercaptan oder Mercaptoessigsäure, halogenorganische Verbindungen, wie Tetrachlormethan geeignet.

Der Zusatz von UV-Absorbern in dem strahlungshärtbaren Gemisch kann ebenfalls Vorteile habe und die Reliefausbildung positiv beeinflussen. Als UV-Absorber kommen Verbindungen wie beispielsweise Hydroxyphenylbenztriazole, Hydroxybenzophenone, Hydroxyphenyl-s-triazine, Oxalanilide, Hydroxyphenylpyrimidine, Salicylsäurederivate und Cyanoacrylate zum Einsatz, wie in A. Valet, Lichtschutzmittel für Lacke, 20ff, Vincentz Verlag Hannover 1996 beschrieben, und beliebige Kombinationen davon.

Weiterhin können Dispergierhilfsmittel, welche Dispergiereigenschaften für Pigmente, Farbstoffe, Nanopartikel oder anorganischen Füllstoffe aufweisen, wie beispielsweise einfach und mehrfach funktionelle Carbon- oder Sulfonsäuren, Alkohole oder Amine, enthalten sein. Als zusätzliche, nicht radikalisch vernetzende Vernetzer, können einfach und mehrfach funktionelle Aldehyde, mehrfach funktionelle Epoxide, mehrfach funktionelle Carbonsäuren und mehrfach funktionelle Carbonsäureanhydride und beliebige Kombinationen in dem strahlungshärtbaren Gemisch mitverwendet werden. Hierzu zählen insbesondere Formaldehyd, Acetaldehyd, Propylaldehyd, Valeraldehyd, Capronaldehyd, Pivalaldehyd, Glyoxal, Glutaraldehyd (1,5 Pentandial), , Succinaldehyd (Butandial),Terephthalaldehyd, 1,2,3,4-Diepoxybutan, 1,2:5,6-Diepoxyhexan, 1,2:7,8-Diepoxyoctan, Epoxidharze, wie Bisphenol-A-diglycidylether und Epoxyphenol-Novolake, Oxalsäure, Malonsäure, Bernsteinsäure, Glutarsäure, Adipinsäure, Pimelinsäure, Korksäure, Suberinsäure, Azelainsäure, Sebacinsäure, Weinsäure, Citronensäure, Terephthalsäure, Phthalsäure, Asparaginsäure, Glutaminsäure, Maleinsäureanhydrid, Bernsteinsäurenahydrid und Phthalsäureanhydrid.

Als Viskositätsveränderer kommen in dem strahlungsempfindliches Gemisch neben wasserlöslichen oder dispergierbaren Polymeren auch Tenside oder oberflächenaktive Substanzen zum Einsatz.

Das strahlungsempfindliche Gemisch enthält mindestens ein niedermolekulares oder hochmolekulares, zur Wasserstoffbrückenbildung fähiges Additiv. Dabei handelt es sich um eine Verbindung, die mit der Komponente A Wasserstoffbrücken ausbildet und ausgewählt ist aus der Gruppe bestehend aus Alkoholen, Ketonen, Aldehyden, Aminen, Amiden, Aminosäuren, Carbonsäuren, Thioethern, Thiolen, Urethanen, Estern, Lactonen, Lactamen und beliebigen Kombinationen davon. Das Wasserstoffbrücken bildende Additiv ist bevorzugt ausgewählt aus der Gruppe bestehend aus Polyolen, Polyaminen, Polyethern, Polyestern, Polyamiden und ionischen Polymeren, beispielsweise anionische Polymere wie Polystyrolsulfonsäure. Als Wasserstoffbrücken akzeptierendes Additiv besonders bevorzugt sind Polyethylenimin, Polyurethane mit Ethylenglykoleinheiten (wie beispielsweise Polyurethanacrylat PUA BIN 200 der Fa. BASF), Polyethylenglycol, wie PEG-400 und PEG-2000, sowie Polyvinylalkohol/Polyethylenglykol-Graft-Copolymere wie Alcotex 97-5 und beliebigen Kombinationen davon. In einer speziellen Ausführungsform der Erfindung handelt es sich bei

dem Wasserstoffbrücken bildenden Additiv um ein Polyvinylalkohol/Polyethylenglykol-Graft-Copolymer.

Das zur Wasserstoffbrückenbildung fähige Additiv liegt in einer Menge von 1 bis 30 Gew.-%, bevorzugt 1 bis 25 Gew.-%, besonders bevorzugt 5 bis 20 Gew.-% und ganz besonders bevorzugt 10 bis 20 Gew.-%, bezogen auf die gesamte Formulierung, vor.

Bevorzugte strahlungshärtbare Gemische enthalten

a) 5 bis 75 Gew.-% der Komponente A
b) 0,1 bis 20 Gew.-% der Komponente B,
c) 0,5 bis 50 Gew.-% der Komponente C,
d) 1 bis 50 Gew.-% der Komponente D.

In einer Ausführungsform enthalten die strahlungshärtbaren Gemische dabei 1 bis 50 Gew.-% der Komponente D, wobei 1 bis 30 Gew.-% davon auf ein zur Wasserstoffbrückenbildung fähiges Additiv entfallen.

In einer besonders bevorzugten Ausführungsform enthalten die strahlungshärtbaren Gemische

a) 5 bis 60 Gew.-% der Komponente A
b) 0,1 bis 10 Gew.-% der Komponente B,
c) 1 bis 40 Gew.-% der Komponente C,
d) 1 bis 40 Gew.-% der Komponente D.

In einer Ausführungsform enthalten die strahlungshärtbaren Gemische dabei 1 bis 40 Gew.-% der Komponente D, wobei 1 bis 25 Gew.-% davon auf ein zur Wasserstoffbrückenbildung fähiges Additiv entfallen.

Die Herstellung des strahlungsempfindliches Gemisches kann mit allen dem Fachmann geläufigen Methoden durch Mischen, Lösen, Dispergieren, Emulgieren oder beliebigen Kombinationen davon erfolgen. Die Reihenfolge der Zugabe der einzelnen Komponenten ist nicht ausschlaggebend, aber es kann vorteilhaft sein, gewisse Komponenten in Teilmischungen zu vereinigen, um dann die Teilmischungen zum fertigen Gemisch zu vereinigen. Bei diesen Schritten können auch Lösungsmittel zum Einsatz kommen, die jedoch zumindest in Teilschritten und zumindest teilweise, bevorzugt größtenteils, wieder entfernt werden, damit das strahlungsempfindliche Gemisch in trockener und ggf. fester, vorzugsweise film- oder schichtförmiger Form vorliegt. Dabei können geringe Mengen oder Spuren im strahlungshärtbaren Gemisch zurück bleiben. Das strahlungsempfindliche Gemisch kann mit den üblichen Methoden (z.B. Gießen, Rakeln, Sprühen, Tauchen) auf Substrate oder Schichten aufgebracht und weiteren Schritten (Trocknen, Verdampfen, Extrudieren, Kalandrieren, Laminieren, Kaschieren) unterzogen werden. Lösemittel werden mit den bekannten Methoden (z.B. Trocknen, Destillieren, Abrotieren, vorgenannte Methoden können bei Normaldruck und/oder Über- bzw. Unterduck durchgeführt werden, Dekantieren,) entfernt und ggf. wiederverwendet werden. In einer Ausführungsform kann das strahlungshärtbare Gemisch auf eine Träger- oder Schutzfolie aufgebracht, z.B. gegossen werden, getrocknet und anschließend auf den metallischen oder polymeren Träger kaschiert werden, wobei auch Lösungsmittel zum Einsatz kommen können. Als Lösemittel können polare Lösungsmitte, insbesondere Wasser und wässrige Lösungen, Alkohole, Ketone und Aldehyde sowie beliebige Mischungen davon eingesetzt werden.

Die Erfindung betrifft weiterhin ein strahlungshärtbares Mehrschichtelement mindestens umfassend eine Schicht aus dem strahlungshärtbaren Gemisch als reliefbildender Schicht auf einem Träger. Das strahlungshärtbare Mehrschichtelement kann weitere Schichten aufweisen.

Die Dicke der strahlungshärtbaren Schicht beträgt im Allgemeinen 0,01 bis 5 mm, bevorzugt 0,01 bis 4 mm, besonders bevorzugt 0,02 bis 3 mm und ganz besonders bevorzugt 0,03 mm bis 3 mm.

Der Träger aus einem dimensionsstabilen Trägermaterial kann optional weitere Schichten aufweisen, beispielsweise eine Haftlackschicht, Oberlackschicht oder Barriereschicht, die sich zwischen dem dimensionsstabilen Träger und der strahlungshärtbaren reliefbildenden Schicht befinden, wobei eine Schicht auch mehrere der genannten Funktionen haben kann. Beispiele für geeignete dimensionsstabiler Träger sind Platten, Folien sowie konische und zylindrische Röhren, sogenannte Sleeves, aus Metallen wie Stahl, Aluminium, Kupfer oder Nickel oder aus Kunststoffen wie Polyethylenterephthalat, Polybutylenterephthalat, Polyamid oder Polycarbonat, aus Geweben oder Vliesen wie Glasfasergewebe oder aus Verbundmaterialien aus Glasfasern und Kunststoffen. Als dimensionsstabile Träger kommen insbesondere dimensionsstabile Trägerfolien oder Metallbleche, beispielsweise Polyethylen- oder Polyesterfolien oder Stahl- oder Aluminiumbleche, in Frage. Diese Trägerfolien oder Metallbleche weisen im Allgemeinen eine Dicke von 50 bis 1500 $\mu$m, vorzugsweise 75 bis 400 $\mu$m, beispielsweise ca. 250 $\mu$m auf. Wird Stahl als Trägermaterial verwendet, sind Stahlbleche mit einer Dicke von 0,05 bis 0,3 mm bevorzugt. Zum Schutz gegen Korrosion werden bevorzugt verzinnte Stahlbleche verwendet. Diese Trägerfolien oder Trägerbleche können mit einer dünnen haftvermittelnden Schicht, beispielsweise einer 0,1 $\mu$m bis 2 $\mu$m dicken Schicht auf der der strahlungshärtbaren reliefbildenden Schicht zugewandten Seite der Trägerfolie beschichtet sein.

Auf dem dimensionsstabilen Träger können sich eine Haftlackschicht und gegebenenfalls eine Oberlackschicht

befinden. Als Haftlackschichten können beispielsweise Schichten aus Polyurethanhaftlacken, z. B. gemäß DE3045516 auf Basis von Polyisocyanat-vernetzten Polyether- oder Polyesterlacken, in Schichtdicken zwischen 0,5 und 50 μm, insbesondere zwischen 2 und 30 μm, fungieren.

Oberlackschichten können sich auf der von der Trägerschicht abgewandten Seite der Haftlackschicht befinden, weisen im Allgemeinen Schichtdicken zwischen 0,1 und 50, insbesondere 1 und 10 μm, auf und können beispielsweise durch Auftragen von verdünnter wässrig-alkoholischer Lösung von teilverseiften (beispielsweise zu 80% verseiften) Polyvinylester, Phenylglycerinethermonoacrylat (2-Hydroxy-3-phenoxypropylacrylat) und Glyoxal, Trocknen und Einbrennen der Oberlackschicht erhalten werden.

Die Haftung im belichteten oder unbelichteten Zustand zwischen den dimensionsstabilen Trägern und der Substratschicht sollte dabei größer sein als 0,5 N/cm, wenn in einem Peeltest bei einem Abzugswinkel von 90°und einer Abzugsgeschwindigkeit von 30 mm/min gemessen wird.

Barriere- oder Schutzschichten können vorhanden sein, um die strahlungshärtbare reliefbildende Schicht vor Umwelteinflüssen wie beispielsweise Licht, Feuchtigkeit, Sauerstoff, oder Ozon zu schützen. Es ist jedoch auch möglich, verschiedene Barriere-Eigenschaften in einer Schicht zu vereinen. Die Barriereschicht kann eine separate Barriereschicht sein oder auch die Trägerschicht, die entsprechende Barriere-Eigenschaften aufweist, sein.

Barriereschichten gegen Licht können aus Kunststoffen bestehen, die selbst entsprechende Wellenlängen absorbieren oder reflektieren, beispielsweise aus Polyethylen-Naphthalat, das im UV-Bereich absorbiert, oder Materialien enthalten, die die entsprechenden Wellenlängen absorbieren oder reflektieren, wie beispielsweise in EP0504824 und EP0767406 beschrieben.

Barriereschichten gegen Feuchtigkeit können aus Polymeren bestehen, die einen niedrigen Diffusionskoeffizienten für Wasser ausweisen. Beispiele sind Polyethylene, Polypropylene, Polyester und Polyvinylalkohle.

Barriereschichten gegen Sauerstoff können eine große Rolle bei der späteren Belichtung mit elektromagnetischen Wellen spielen, da radikalisch verlaufende Reaktionen durch Sauerstoff stark beeinflusst und gebremst werden. Als Materialien für Barriereschichten werden sowohl wasserlösliche als auch in organischen Lösungsmitteln lösliche Bindemittel vorgeschlagen, nämlich Polyamide, Polyvinylalkohole, Hydroxyalkylcellulosen, Ethylen-VinylacetatCopolymere, amphotere Interpolymere, Celluloseacetatbutyrat, Alkylcellullose, Butyral, cyclische Kautschuke und Kombinationen davon. Bevorzugt werden Polyvinylalkohol, teil- und hochverseifte Polyvinylcarboxylat, Poly(ethylenoxid-vinylalcohol) Pfropfcopolymere oder Poly(ethylenvinylalkohol)-Copolymere eingesetzt. Die Dicke der Barriereschicht beträgt in der Regel 0,2 μm bis 10 μm, bevorzugt 0,3 bis 8 μm.

Vorzugsweise weist das strahlungshärtbare Mehrschichtelement auf der strahlungshärtbaren reliefbildenden Schicht eine oder mehrere weitere Schichten auf. Diese weiteren Schichten können eine Schutzschicht, eine Barriereschicht, eine Maskenschicht, eine Haftschicht, eine Release-Schicht (Entklebungsschicht) oder einer Schicht zur Erzeugung einer Oberflächenstruktur sein, wobei eine Schicht auch zwei oder mehr der genannten Funktionen aufweisen kann und diese Schichten in beliebigen Reihenfolgen und Kombinationen vorliegen können. Schichten, die nicht mechanisch, beispielsweise durch Abziehen, entfernt werden, sind dabei im Allgemeinen zumindest teilweise wasserlöslich oder wasserdispergierbar.

Als äußerste Schicht weist das strahlungshärtbare Mehrschichtelement im Allgemeinen eine Schutzschicht, vorzugsweise eine Schutzfolie, auf, die die strahlungshärtbare Schicht vor mechanischen Schäden, z.B. durch Kratzer, Schmutz oder Staub schützt. Diese Schutzschicht wird in der Regel vor weiteren Verarbeitungsschritten entfernt. Die Schutzschicht ist im Allgemeinen eine dünne und vorzugsweise ebenfalls dimensionsstabile Kunststofffolie aus Polyestern, z.B. Polyethylenterephthalat oder Polybutylenterephthalat), Polyamiden, Polyurethanen oder Polyethylen. Um die strahlungshärtbare Schicht vor Licht zu schützen, kann die Schutzschicht auch lichtabsorbierende Materialien enthalten und damit eine vorzeitige unerwünschte Polymerisation in der strahlungshärtbaren Schicht verhindern.

Die Barriereschicht befindet sich im allgemeinen in direktem Kontakt mit der strahlungshärtbaren Schicht und verhindert, dass unerwünschte niedermolekulare Stoffe aus der Umgebung (z.B. Feuchtigkeit, Sauerstoff, oder Ozon oder Kombinationen davon) oder aus anderen Schichten (z.B. Farbstoffe, UV-Absorber) in die strahlungshärtbare Schicht eindiffundieren, oder sie verhindert, dass niedermolekulare Stoffe aus der strahlungshärtbaren Schicht (z.B. Initiator, Monomer) in die darüber liegenden Schichten eindiffundieren. Andere Anordnungen, bei der die Barriereschicht an anderer Stelle positioniert ist oder mehrere Barriereschichten zum Einsatz kommen, sind ebenfalls möglich. Geeignete Barriereschichten gegen Feuchtigkeit, Licht und Sauerstoff sind die oben beschrieben Barriereschichten.

Barriereschichten gegen Bestandteile der strahlungshärtbaren Schicht und/oder der über der Barriereschicht befindlichen Schicht weisen einen hohen Diffusionswiderstand gegen die migrierenden Stoffe aufweisen. Die Barriereschichten sind im Allgemeinen zumindest teilweise wasserlöslich oder wasserdispergierbar.

Haftschichten erhöhen die Haftung zwischen einzelnen Schichten und stabilisieren den Schichtaufbau. Solche Schichten enthalten Stoffe, die zu beiden angrenzenden Schichten eine Wechselwirkung aufweisen, im Allgemeinen Tenside, amphiphile Moleküle mit hydrophoben und hydrophilen Bereichen und Blockcopolymere und Oligomere, die Blöcke enthalten, die mit den beiden Schichten kompatibel oder mit den polymeren in den angrenzenden Schichten verträglich sind.

Release-Schichten verringern die Haftung zwischen einzelnen Schichten und erleichtern beispielsweise das Abziehen einer anderen Schicht wie beispielsweise einer Schutzfolie. Diese Schichten können an verschiedensten Positionen im Schichtaufbau lokalisiert sein und zur einfachen Entfernung von einer oder mehreren Schichten eingesetzt werden.

Eine Schicht zur Erzeugung einer Oberflächenstruktur auf der strahlungshärtbaren Schicht befindet sich im Allgemeinen in direktem Kontakt mit der strahlungshärtbaren Schicht und bewirkt, dass am Ende der Verarbeitungsschritte eine Oberfläche mit einer Struktur oder Rauigkeit vorliegt. Dies kann durch Präge- oder Abformvorgänge während der Herstellung des Schichtverbundes erfolgen.

Die Maskenschicht ermöglicht das bildmäßige Belichten der strahlungshärtbaren Schicht und enthält mindestens ein Material, das die elektromagnetische Strahlung, die zur Belichtung verwendet werden sollen, absorbiert und/oder reflektiert, sowie ein Material, das ermöglicht, dass die Maskenschicht durch die Bebilderung lokal entweder entfernt und/oder in ihren Absorptions- oder Reflexionseigenschaften so verändert wird, dass die Schicht im zur Bebilderung verwendeten Wellenlängenbereich zumindest teilweise transparent wird. Die Maskenschicht enthält darüber hinaus weitere Bestandteile wie Bindemittel und Additive, die für eine gute Verarbeitbarkeit, Filmbildung und Entwicklung sorgen. Vorzugsweise ist die Maskenschicht eine laserablative Maskenschicht. Hierbei wird die Maskenschicht durch den hohen Energieeintrag durch die Laserstrahlung entfernt und zwar nur dort, wo der Laserstrahl auf die Maskenschicht auftrifft. Auf diese Weise entsteht ein negatives Abbild der zu erzeugenden Reliefstruktur in der Maskenschicht. Durch nachfolgendes Belichten mit elektromagnetischen Wellen in den belichteten Bereichen der strahlungsempfindlichen Schicht wird eine Vernetzung und/oder Polymerisation bewirkt. Die belichteten Bereiche bleiben nach dem Entfernen des unbelichteten Materials als Reliefstruktur übrig. Bevorzugt ist die Verwendung von IR-Lasern zur Ablation der Maskenschicht. Im Allgemeinen wird die Belichtung mit elektromagnetischer Strahlung im UV-Bereich durchgeführt. Derartige laserablative Maskenschichten sind beispielsweise in WO 94/03839, US 5,262,275, WO 94/03838 und EP 0 767 406 beschrieben.

Die laserablative Maskenschicht enthält im Allgemeinen ein oder mehrere wasserlösliche oder wasserdispergierbare oder in wässrig/alkoholisch Lösungsmittelgemischen lösliche oder dispergierbare Bindemittel und fein verteiltem IR-Licht absorbierendem Material mit einer starken Absorption im Wellenlängenbereich von 750 bis 20 000 nm, bevorzugt von 750 bis 5000 nm und gegebenenfalls einen Weichmacher. Die IR-lichtempfindliche Maskenschicht weist gegenüber aktinischem Licht eine optische Dichte von ≥ 2,5, bevorzugt zwischen 3 und 5 auf. Beispiele für derartige Bindemittel sind teilverseifte Polyvinylester, z.B. teilverseifte Polyvinylacetate, Polyvinylalkoholderivate, wie z.B. teilverseiftes Vinylacetat/Alkylenoxid-Pfropfmischpolymerisat, Maleinsäureanhydridcopolymere wie z.B. Copolymere aus Maleinsäureanhydrid und Isobuten oder Maleinsäureanhydrid und Vinylmethylether, wasserlösliche Polyester, wasserlösliche Polyether, Homo- und Copolymere von Vinylpyrrolidon, Vinylcaprolactam, Vinylimidazol, Vinylacetat, Acrylamid, wasserlösliche Polyurethane, wasserlösliche oder in Wasser-Alkohol-Mischungen lösliche Polyamide oder Mischungen dieser Polymeren.

Als IR-absorbierendes Material können Farbstoffe und/oder Pigmente eingesetzt werden. Als Farbstoffe können beispielsweise Phthalocyanine und substituierte Phthalocyanin-Derivate, Cyanin-, und Merocyaninfarbstoffe oder auch Polymethinfarbstoffe verwendet werden. Als Pigmente können z.B. Ruß, Graphit, Chromoxid oder Eisenoxide eingesetzt werden.

Das IR-absorbierende Material wird in der Konzentration eingesetzt, in der es für die erfindungsgemäße Anwendung wirksam ist. Im Allgemeinen werden 1 bis 60 Gew.-%, bezogen auf das Gesamtgewicht der gegen IR-Strahlung empfindlichen Maskenschicht, benötigt. Um die IR-lichtempfindliche Maskenschicht gegenüber aktinischem Licht undurchlässig zu machen, können alle Verbindungen eingesetzt werden, die UV-Licht absorbieren. Beispiele sind die oben genannten Farbstoffe und Pigmente. Die meisten Initiatoren in lichtempfindlichen Schichten sind empfindlich gegenüber UV-Licht. Deshalb wird häufig Ruß als Pigment in der IR-lichtempfindlichen Schicht verwendet. Bei Verwendung von Ruß als Pigment in der IR-lichtempfindlichen Schicht kann auf die Verwendung eines weiteren IR-absorbierenden Materials verzichtet werden. Die Konzentration des für aktinisches Licht undurchlässigen Materials wird so gewählt, dass die notwendige optische Dichte erreicht wird. Im Allgemeinen wird eine optische Dichte größer 2,5 benötigt. Bei Verwendung von Ruß als Pigment in der IR-lichtempfindlichen Schicht werden ca. 1 bis 60 Gew. -%, bevorzugt 1 bis 40 Gew. -%, bezogen auf das Gesamtgewicht der IR-lichtempfindlichen Maskenschicht) verwendet.

Gegenstand der Erfindung ist auch ein Verfahren zur Herstellung eines strahlungshärtbaren Mehrschichtelements, umfassend das Aufbringen einer Schicht aus dem strahlungshärtbaren Gemisch auf einen Träger. Dieses Verfahren umfasst ganz allgemein, in der Reihenfolge a) bis g), die Schritte

a) Bereitstellen eines Trägers,
b) optional Reinigen des Trägers,
c) optional Aufbringen einer oder mehreren weiteren Schichten,
d) Aufbringen mindestens einer Schicht aus dem strahlungshärtbaren Gemisch,
e) optional weitere Behandlung des Schichtverbunds, vorzugsweise durch Trocknen,

f) optional Aufbringen einer oder mehrerer weiterer Schichten,
g) optional weitere Behandlung des Schichtaufbaus.

In Schritt a) wird ein dimensionsstabiler Träger bereitgestellt, der zusätzlich mit weiteren Schichten (z.B. einer Haftvermittlerschicht, einer Barriereschicht, einer Lackschicht) versehen sein kann.

Im optionalen Schritt b) wird eine Reinging der Oberfläche des Trägers, der gegebenenfalls mit weiteren Schichten oder direkt mit dem strahlungshärtbaren Gemisch beschichtet wird, erfolgen. Dabei werden vor allem Staub und Fremdpartikel, aber auch flächige Verschmutzungen, die die Haftung beeinträchtigen (z.B. Fingerabdrücke) entfernt. Zum Einsatz können hier alle dem Fachmann geläufigen Methoden kommen können, wie beispielsweise bürsten, abblasen, wischen (mit und ohne Lösemittel), abspülen und beliebige Kombinationen davon. Im Allgemeinen wird eine derartige Reinigung durchgeführt.

Im optionalen Schritt c) können eine oder mehrere weitere Schichten aufgebracht werden, beispielsweise eine Haftvermittler- oder Zwischenschicht, eine Barriereschicht oder eine Lackschicht, sowie geeignete Kombinationen dieser Schichten. Das Aufbringen der weiteren Schichten kann mit allen dem Fachmann geläufigen Methoden erfolgen, wie beispielsweise durch Kalandrieren, Laminieren, Extrusion, Gießen, Tauchen, Sprühen, Lackieren oder Kaschieren, sowie geeigneten Kombinationen davon. Vorzugsweise wird in Schritt c) eine Trägerfolie oder ein Trägerblech mit einer Haftschicht beschichtet und diese eingebrannt oder getrocknet. Es können auch Trägerfolien, bevorzugt Trägerfolien aus Polyethylenterephthalat, Polybutylenterephthalat, Polyamid und/oder Polycarbonat, zum Einsatz kommen, die mit einer Haftvermittlerschicht beschichtet sind.

In Schritt d) wird mindestens eine Schicht aus dem strahlungshärtbaren Gemisch aufgetragen, wobei zwischen dem Auftrag mehrerer Schichten weitere Prozessschritte durchgeführt werden können, wie beispielsweise Trocknen, Bestrahlen oder Besprühen und geeignete Kombinationen davon. Das Aufbringen des strahlungshärtbaren Gemischs kann mit allen dem Fachmann geläufigen Methoden erfolgen, wie beispielsweise Laminieren, Kaschieren, Gießen, Tauchen, Sprühen und geeigneten Kombinationen davon. Dabei kann es erforderlich sein, dass das strahlungshärtbare Gemisch und/oder die Schichten erwärmt oder gekühlt werden.

In Abhängigkeit der Auftragsmethode in Schritt d) kann es erforderlich sein, in Schritt e) weitere Behandlungen des Schichtaufbaus durchzuführen. Insbesondere, wenn flüssige oder lösungsmittelhaltige Gemische aufgetragen werden, kann es erforderlich sein, dass Trocknungsschritte durch Erwärmen des Schichtverbunds oder Verdampfen von Lösungsmittel im Vakuum durchgeführt werden. Weiterhin kann es nötig sein, den Schichtaufbau mechanisch zu behandeln, beispielsweise durch Walzen oder Pressen. Außerdem kann es vorteilhaft sein den Schichtaufbau in diesem Stadium von mindestens einer Seite, die entsprechend transparent ist, mit elektromagnetischen Wellen zu bestrahlen.

Vorzugsweise wird das strahlungsempfindliche Gemisch auf ein dimensionsstabiles Blech, insbesondere aus Aluminium oder Stahl, das die eine Oberlackschicht aufweist, z.B. aus verdünnter wässrig/alkoholischer Lösung von teilverseiften Polyvinylestern, Phenylglycerinethermonoacrylat und Glyoxal, oder eine dimensionsstabile Folie, vorzugsweise aus PET, die eine Haftschicht aus Polyurethanhaftlack, z.B. gemäß DE 3045516 A1 auf Basis von Polyisocyanat-vernetzenden Polyether- oder Polyesterlacken, aufweist, durch Gießen aufgetragen und in einem Trocknungskanal durch Erwärmen auf 50 bis 200 °C getrocknet.

Die Dicke der aufgetragenen und ggf. behandelten strahlungshärtbaren Schicht beträgt im Allgemeinen von 0,01 bis 5 mm, bevorzugt 0,01 bis 4 mm, besonders bevorzugt 0,02 bis 3 mm und ganz besonders bevorzugt 0,03 mm bis 3 mm.

Im optionalen Schritt f) können ein oder mehrere weitere Schichten auf die strahlungshärtbare, reliefbildende Schicht aufgebracht werden. Hierbei kann es sich um eine Schutzschicht, eine Barriereschicht, eine Maskenschicht, eine Haftschicht, eine Release-Schicht, eine Schicht zur Erzeugung einer Oberflächenstruktur sowie geeignete Kombinationen dieser Schichten handeln. Das Aufbringen der weiteren Schicht oder Schichten kann mit allen dem Fachmann geläufigen Methoden erfolgen, wie beispielsweise durch Kalandrieren, Kaschieren, Laminieren, Walzen, Extrudieren, Gießen, Tauchen, Sprühen und geeigneten Kombinationen davon. Auch dabei kann es erforderlich sein, weitere Behandlungen des Schichtaufbaus durchzuführen. Insbesondere wenn flüssige oder lösungsmittelhaltige Gemische aufgetragen werden, kann es erforderlich sein, Trocknungsschritte durch Erwärmen des Schichtverbunds oder Verdampfen des Lösungsmittels im Vakuum durchzuführen. Im Allgemeinen wird zumindest eine Schutzschicht, vorzugsweise eine Schutzfolie, aufgetragen, was vorzugsweise durch Laminieren oder Kaschieren erfolgt.

In einer Ausführungsform kann das strahlungshärtbare Gemisch auf eine Träger- bzw. Schutzfolie aufgebracht, z. B aufgegossen, getrocknet und anschließend auf den metallischen oder polymeren Träger kaschiert werden, wobei auch Lösungsmittel zum Einsatz kommen können. Es ist auch möglich, das strahlungshärtbare Gemisch auf einen Träger zu applizieren und die weitere Schicht auf eine Folie aufzutragen und anschließend die Folie mit der weiteren Schicht auf das strahlungsempfindliche Gemisch zu laminieren. Wenn Schichten oder das strahlungshärtbare Gemisch in einem vorhergehenden Schritt erwärmt wurden, kann es vorteilhaft sein, die gebildete Schichtstruktur aktiv zu kühlen.

Optional kann der Schichtaufbau in Schritt g) weiteren Behandlungen unterzogen werden, die für die weitere Verarbeitung vorteilhaft sind. Dazu gehören beispielsweise eine Belichtung mit elektromagnetischen Wellen von zumindest einer der beiden Seiten der Schichtstruktur (die entsprechend transparent ist), eine optische Qualitätskontrolle auf Defekte und/oder Verunreinigungen, ein Zuschneiden in vorbestimmte Formate, eine thermische Behandlung, eine Verpackung, eine Lagerung und beliebige Kombinationen davon.

Die vorliegende Erfindung betrifft auch ein Verfahren zur Herstellung einer Reliefstruktur aus dem strahlungshärtbaren Mehrschichtelement, umfassend das Bestrahlen der reliefbildenden Schicht durch die Maskenschicht und das Entfernen der nicht bestrahlten, nicht gehärteten Bereiche der reliefbildenden Schicht.

Ganz allgemein umfasst das Verfahren die Schritte:

a) Bereitstellen des strahlungshärtbaren Mehrschichtelement,
b) optional Reinigen der strahlungshärtbaren Mehrschichtelement,
c) optional Bestrahlung mit elektromagnetischer Strahlung von einer ersten Seite,
d) optional Entfernen einer Schutzschicht,
e) optional Aufbringen einer Maskenschicht,
f) Bebilderung der Maskenschicht ,
g) Bestrahlung mit elektromagnetischer Strahlung durch die Maskenschicht,
h) optional Entfernung der Maskenschicht,
i) Entfernung der nicht bestrahlten Bereiche,
j) optional weitere Behandlungsschritte.

Im ersten Schritt a) wird das beschriebene strahlungshärtbare Mehrschichtelement bereitgestellt. Diese kann optional in Schritt b) gereinigt werden, wobei alle dem Fachmann geläufigen Methoden kommen können, wie beispielsweise bürsten, abblasen, wischen (mit und ohne Lösemittel), abspülen und beliebige Kombinationen davon.

Im optionalen Schritt c) kann das strahlungshärtbare Mehrschichtelement von mindestens einer Seite großflächig mit elektromagnetischer Strahlung (siehe oben) bestrahlt werden. Diese Bestrahlung erfolgt vorzugsweise von der Seite der strahlungshärtbaren Schicht, die der Maskenschicht gegenüber liegt, um eine Versockelung der zu erzeugenden Reliefstruktur zu erreichen (Rückseitenbelichtung). Vorzugsweise erfolgt diese Rückseitenbelichtung durch transparente dimensionsstabile Materialien wie beispielsweise Polymerfilme und insbesondere Polyesterfilme als Trägermaterial.

Bei Vorliegen einer Schutzschicht, kann diese im optionalen Schritt d) entfernt werden, was sowohl mechanisch als auch chemisch durch Behandlung mit Lösungsmitteln, Wasser oder wässrigen Lösungen möglich ist. Vorzugsweise ist die Schutzschicht eine Schutzfolie und wird abgezogen.

Falls das strahlungshärtbare Mehrschichtelement keine Maskenschicht enthält, kann diese Maskenschicht im optionalen Schritt e) aufgebracht werden. Die Maskenschicht kann dabei bereits bebildert sein, dann entfällt Schritt f). Das Aufbringen der Maskenschicht kann mit allen dem Fachmann bekannten Methoden erfolgen, wie beispielsweise Auflegen, Kalandrieren, Laminieren, Walzen, Extrusion, Gießen, Tauchen, Sprühen, Kaschieren und geeignete Kombinationen davon. Gegebenenfalls können, insbesondere bei der Auftragung von flüssigen Formulierungen, weitere Behandlungsschritte nötig sein, wie beispielsweise Trocknen, Walzen und/oder Abkühlen. Vorzugsweise wird die Maskenschicht aufgelegt oder auflaminiert.

Die Reihenfolge der Schritte b), c),d) und e) kann dabei in geeigneter Weise variiert werden.

Im Schritt f) erfolgt die Bebilderung der Maskenschicht und dieser Schritt ist nur dann optional, wenn in Schritt e) eine bebilderte Maskenschicht aufgebracht oder die strahlungsempfindliche Schicht direkt belichtet wird, wie es beispielsweise mittels geführter Laserstrahlen oder einer ortsaufgelöster Projektion von elektromagnetischer Strahlung. Die Bebilderung der Maskenschicht erfolgt entweder durch eine Entfernung der Schicht und/oder eine ortsaufgelösten Veränderung der Absorptions- und/oder Reflexionseigenschaften so, dass die Maskenschicht im zur Bebilderung verwendeten Wellenlängenbereich zumindest teilweise transparent wird. Vorzugsweise wird eine Maskenschicht verwendet, die sich mittels IR Lasern ablatieren lässt.

In Schritt g) erfolgt die Bestrahlung des Mehrschichtelements mit elektromagnetischer Strahlung von der Seite der strahlungsempfindlichen Schicht, die dem dimensionsstabilen Material gegenüberliegt und setzt die strahlungsinduzierte Polymerisations- und Vernetzungsreaktion in Gang. Die Bestrahlung kann beim Vorliegen einer bebilderten Maske großflächig erfolgen oder, falls ohne Maskenschicht gearbeitet wird, bildgebend kleinflächig (annähernd punktförmig) mittels geführten Laserstrahlen oder ortsaufgelöster Projektion von elektromagnetischer Strahlung. Die Wellenlänge der eingestrahlten elektromagnetischen Wellen liegt dabei im Bereich von 200 bis 2000 nm, wie oben bereits beschrieben.

Die Bestrahlung kann dabei kontinuierlich oder gepulst oder in mehreren kurzen Perioden mit kontinuierlicher Strahlung erfolgen. Die Intensität der Strahlung kann dabei über einen weiten Bereich variiert werden, wobei sicher zu stellen ist, dass eine Dosis verwendet wird, die ausreicht, um die strahlungshärtbare Schicht für den späteren Entwicklungsvorgang ausreichend zu härten. Die strahlungsinduzierte Reaktion muss ggf. nach weiteren thermischen Behandlungen soweit fortgeschritten sein, dass die belichteten Bereiche der strahlungsempfindlichen Schicht mindestens teilweise unlöslich werden und somit im Entwicklungsschritt nicht entfernt werden können. Intensität und Dosis der Strahlung sind abhängig von der Reaktivität der Formulierung und der Dauer und Effizienz der Entwicklung. Die Intensität der Strahlung liegt im Bereich von 1 bis 15000 mW/$cm^2$, bevorzugt im Bereich von 5 bis 5000 mW/$cm^2$, besonders bevorzugt im Bereich von 10 bis 1000 mW/$cm^2$. Die Dosis der Strahlung liegt im Bereich von 0,3 bis 6000 J/$cm^2$, bevorzugt im Bereich von 3 bis 100 J/$cm^2$, besonders bevorzugt im Bereich von 6 bis 20 J/$cm^2$. Das Einwirken der Energiequelle kann auch in einer inerten Atmosphäre, beispielsweise in Edelgasen, $CO_2$ und/oder Stickstoff oder unter einer Flüssigkeit, die das Mehrschichtelement nicht beschädigt, durchgeführt werden.

In Schritt h) kann optional die Maskenschicht entfernt werden, was sowohl mechanisch als auch chemisch durch Behandlung mit Lösungsmitteln, Wasser oder wässrigen Lösungen möglich ist. Eine separate Entfernung der Maskenschicht bietet sich insbesondere dann an, wenn sich die Schicht als Ganzes mechanisch abziehen lässt, bzw. wenn die Maskenschicht lediglich aufgelegt oder auflaminiert wurde. Wenn ohne Maskenschicht gearbeitet wird, entfällt dieser Schritt.

Zur Erzeugung der Reliefstruktur werden in Schritt i) die in Schritt g) nicht belichteten Bereiche der strahlungshärtbaren Schicht entfernt. In diesem Entwicklungsschritt können alle dem Fachmann geläufigen Methoden angewendet werden. Die Bestrahlung bewirkt eine Polymerisation und/oder Vernetzung in der strahlungshärtbaren Schicht, wodurch diese weniger löslich wird. Deshalb werden zur Entfernung der nicht belichteten Bereiche als Entwicklungsmedien Lösungsmittel, Wasser und/oder wässrige Lösungen eingesetzt. Die Lösungsmittel und wässrigen Lösungen können Hilfsmittel enthalten, die die Formulierung stabilisieren und/oder die Löslichkeit der Komponenten der strahlungshärtbaren Schicht erhöhen. Beispiele für derartige Hilfsmittel sind Emulgatoren, Tenside, Salze, Säuren, Basen, Stabilisatoren, Korrosionsschutzmittel und geeignete Kombinationen davon. Zur Entwicklung mit diesen Lösungen können alle dem Fachmann bekannten Methoden eingesetzt werden, wie beispielsweise Tauchen, Waschen oder Besprühen mit dem Entwicklungsmedium, Bürsten in Anwesenheit von Entwicklungsmedium und geeignete Kombinationen davon. Bevorzugt wird mit neutralen wässrigen Lösungen oder Wasser entwickelt, wobei das Entfernen mittels rotierender Büsten oder einem Plüschflor unterstützt wird. Eine weitere Möglichkeit, die Entwicklung zu beeinflussen, besteht darin, die Temperatur des Entwicklungsmediums zu steuern und beispielswiese durch Erhöhung der Temperatur die Entwicklung zu beschleunigen. In diesem Schritt können auch weitere Schichten, die noch auf der strahlungsempfindlichen Schicht vorhanden sind, entfernt werden, wenn diese Schichten beim Entwickeln abgelöst und im Entwicklermedium ausreichend gelöst und/oder dispergiert werden können.

Optional können anschließend an die vorhergehenden Schritte weitere Behandlungsschritte durchgeführt werden (Schritt j). Dazu gehören beispielsweise eine thermische Behandlung, eine Trocknung, eine Behandlung mit elektromagnetischer Strahlung, Anbringung von Identifikationsmerkmalen, Zuschneiden, Beschichtung und beliebige Kombinationen davon. Eine thermische Behandlung kann beispielsweise zum Start und/oder zur Vervollständigung von Reaktionen, zur Erhöhung der mechanischen und/oder thermischen Beständigkeit der Reliefstruktur und, zur Entfernung von flüchtigen Bestandteilen genutzt werden. Zur thermischen Behandlung können die bekannten Methoden verwendet werden, wie beispielsweise Erwärmung durch erwärmte Gase oder Flüssigkeiten, IR-Strahlung und beliebige Kombinationen davon. Dabei können Öfen, Gebläse, Lampen und beliebige Kombinationen davon und zum Einsatz kommen.

Eine Behandlung mit elektromagnetischer Strahlung kann beispielsweise dazu verwendet werden, um die Oberflächen der Reliefstruktur klebfrei zu machen, die Polymerisations- und/oder Vernetzungsreaktionen auszulösen und/oder zu vervollständigen. Die Wellenlänge der eingestrahlten elektromagnetischen Wellen liegt dabei im Bereich von 200 bis 2000 nm wie oben bereits beschrieben.

In einer Ausführungsform umfasst das Verfahren zur Herstellung eines Mehrschichtelements mit einer Reliefstruktur aus einem strahlungshärtbaren Mehrschichtelement das Bestrahlen der reliefbildenden Schicht und das Eingravieren eines Reliefs in bestrahlte, gehärtete Bereiche der reliefbildenen Schicht. Ganz Allgemein umfasst dieses Verfahren die folgenden Schritte:

a) Bereitstellen des strahlungsempfindlichen Mehrschichtelements,
b) optional Reinigen des strahlungsempfindlichen Mehrschichtelements,
c) optional Bestrahlung mit elektromagnetischer Strahlung von der Rückseite,
d) optional Entfernen einer Schutzschicht,
e) Bestrahlung der strahlungshärtbaren Schicht mit elektromagnetischer Strahlung,
f) bildgebendes Abtragen mindestens eines Teils der strahlungshärtbaren Schicht,
g) optional weitere Behandlungsschritte.

Im ersten Schritt a) wird das strahlungshärtbare Mehrschichtelement bereitgestellt. Diese kann optional in Schritt b) gereinigt werden, wobei alle dem Fachmann geläufigen Methoden kommen können, wie beispielsweise bürsten, abblasen, wischen (mit und ohne Lösemittel), abspülen und beliebige Kombinationen davon.

Im optionalen Schritt c) kann das strahlungshärtbare Mehrschichtelement von der Rückseite großflächig mit elektromagnetischen Wellen bestrahlt werden, wenn diese Seite des strahlungshärtbaren Mehrschichtelements für die

verwendeten Wellenlängen transparent ist. Diese Bestrahlung erfolgt von der Seite der strahlungsempfindlichen Schicht, die der Maskenschicht gegenüber liegt, um eine Versockelung der zu erzeugenden Reliefstruktur zu erreichen (Rückseitenbelichtung). Vorzugsweise erfolgt diese Rückseitenbelichtung durch transparente dimensionsstabile Materialien wie beispielsweise Polymerfilme und insbesondere Polyesterfilme.

Die Wellenlänge der eingestrahlten elektromagnetischen Wellen liegt dabei im Bereich von 200 bis 2000 nm, wie oben bereits beschrieben.

Bei Vorliegen einer Schutzschicht, kann diese im optionalen Schritt d) entfernt werden, was sowohl mechanisch als auch chemisch durch Behandlung mit Lösungsmitteln, Wasser oder wässrigen Lösungen möglich ist. Vorzugsweise wird die Schutzschicht abgezogen.

Die Reihenfolge der Schritte b), c) und d) kann dabei beliebig variiert werden. In Schritt e) erfolgt die Bestrahlung der Schichtstruktur mit elektromagnetischen Wellen von der Seite der strahlungsempfindlichen Schicht, die dem dimensionsstabilen Material gegenüberliegt und setzt die strahlungsinduzierte Reaktion in Gang. Die Bestrahlung kann großflächig erfolgen aber auch kleinflächig (annähernd punktförmig) mittels geführten Laserstrahlen oder durch Projektion von elektromagnetischer Strahlung. Die Wellenlänge der eingestrahlten elektromagnetischen Wellen liegt dabei im Bereich von 200 bis 2000 nm, wie oben bereits beschrieben.

Die Bestrahlung kann dabei kontinuierlich oder gepulst oder in mehreren kurzen Perioden mit kontinuierlicher Strahlung erfolgen. Die Intensität der Strahlung kann dabei über einen weiten Bereich variiert werden, wobei sicher zu stellen ist, dass eine Dosis verwendet wird, die ausreicht, um die strahlungsempfindliche Schicht für den späteren Gebrauch ausreichend zu verändern. Die strahlungsinduzierte Reaktion muss ggf. nach weiteren thermischen Behandlungen soweit fortgeschritten sein, dass die belichteten Bereiche der strahlungsempfindlichen Schicht stabil sind. Intensität und Dosis der Strahlung sind abhängig von der Reaktivität der Formulierung und der Aggressivität der Entwicklung. Die Intensität der Strahlung liegt im Bereich von 1 bis 15000 $mW/cm^2$, bevorzugt im Bereich von 5 bis 5000 $mW/cm^2$, besonders bevorzugt im Bereich von 10 bis 1000 $mW/cm^2$. Die Dosis der Strahlung liegt im Bereich von 0,3 bis 6000 $J/cm^2$, bevorzugt im Bereich von 3 bis 100 $J/cm^2$, besonders bevorzugt im Bereich von 6 bis 20 $J/cm^2$. Das Einwirken der Energiequelle kann auch in einer inerten Atmosphäre, beispielsweise in Edelgasen, $CO_2$ und/oder Stickstoff oder unter einer Flüssigkeit, die das Mehrschichtelement nicht beschädigt, durchgeführt werden.

Die Reliefstruktur wird im Schritt f) durch bildgebendes Abtragen mindestens eines Teils der strahlungsempfindlichen Schicht bewerkstelligt. Die kann mittels mechanischer Methoden oder durch Ablation mit energiereicher Strahlung erfolgen. Bei den mechanischen Methoden werden mit mindestens einem Werkzeug spezifische Bereiche der strahlungsempfindlichen Schicht entfernt und dadurch eine Bildgebung erzielt. Zur Steuerung der Werkzeuge können computergestützte Verfahren eingesetzt werden. Bei der Ablation mit energiereicher Strahlung werden Strahlen computergestützt über die strahlungsempfindliche Schicht geführt und im bestrahlten Bereich Material entfernt. Die Wellenlänge der eingestrahlten elektromagnetischen Wellen liegt dabei im Bereich von 500 nm bis 100 $\mu$m, bevorzugt im IR-Bereich, besonders bevorzugt im Bereich von 500 nm bis 50 $\mu$m, ganz besonders bevorzugt im Bereich von 800 nm bis 20 $\mu$m. Neben breitbandiger Einstrahlung der elektromagnetischen Wellen kann es vorteilhaft sein, schmalbandige oder monochromatische Wellenlängenbereiche zu verwenden, wie sie unter Einsatz von Niederdruck-, Hochdruck-, Fluoreszenz- und/oder Blitzlichtlampen mit entsprechenden Filtern, Lasern oder Light Emitting Diodes (LEDs) erzeugt werden können. In diesen Fällen sind Wellenlängen in den Bereichen 830 nm, 980 nm, 1064 nm und 10,6 $\mu$m einzeln oder als Kombinationen bevorzugt. Vorzugsweise werden LEDs und Fluoreszenzlampen oder Leuchtstoffröhren eingesetzt und beliebig miteinander kombiniert. Die Strahlungsleistung liegt dabei im Bereich von 1 bis 100 W, bevorzugt im Bereich von 2 bis 50 W, besonders bevorzugt im Bereich von 5 bis 30 W. Die Dosis der Strahlung liegt im Bereich von 1 bis 100 $mJ/cm^2$, bevorzugt im Bereich von 2 bis 80 $mJ/cm^2$, besonders bevorzugt im Bereich von 3 bis 50 $mJ/cm^2$.

Die bei diesem Verfahren erzielbare Relieftiefe ist durch die Schichtdicke der aufgetragenen strahlungsempfindlichen Schicht nach oben begrenzt und liegt im Bereich von 10 bis 1000 $\mu$m, bevorzugt im Bereich von 20 bis 500 $\mu$m, besonders bevorzugt im Bereich von 30 bis 100 $\mu$m. Optional können anschließend an die vorhergehenden Schritte weitere Behandlungsschritte durchgeführt werden (Schritt j). Dazu gehören beispielsweise eine thermische Behandlung, eine Trocknung, eine Behandlung mit elektromagnetischen Strahlen, Anbringung von Identifikationsmerkmalen, Zuschneiden, Beschichtung und beliebige Kombinationen davon. Eine thermische Behandlung kann beispielswiese zum Start und/oder zur Vervollständigung von Reaktionen, zur Erhöhung der mechanischen und/oder thermischen Beständigkeit der Reliefstruktur und zur Entfernung von flüchtigen Bestandteilen genutzt werden. Zur thermischen Behandlung können die bekannten Methoden verwendet werden, wie beispielsweise Erwärmung durch erwärmte Gase oder Flüssigkeiten, IR-Strahlung und beliebige Kombinationen davon. Dabei können Öfen, Gebläse, Lampen und beliebige Kombinationen davon und zum Einsatz kommen.

Eine Behandlung mit elektromagnetischer Strahlung kann beispielsweise dazu verwendet werden, um die Oberflächen der Reliefstruktur klebfrei zu machen, die Polymerisations-und/oder Vernetzungsreaktionen auszulösen und/oder zu vervollständigen. Die Wellenlänge der eingestrahlten elektromagnetischen Wellen liegt dabei im Bereich von 200 bis 2000 nm, wie oben bereits beschrieben.

Weiterhin betrifft die Erfindung die Verwendung der nach den oben genannten Ausführungsformen hergestellten

Reliefstrukturen zum Drucken. Dabei können sie beispielsweise in Hochdruck als auch Tiefdruckverfahren, sowie im Tampondruck eingesetzt werden.

Die Erfindung wird durch die nachstehenden Beispiele näher erläutert.

Beispiele

Methoden:

Methode zur Bestimmung des Funktionalisierungsgrades:

In einem ersten Schritt werden die zu messenden Proben gereinigt, um sie von Reaktionsrückständen, insbesondere Monomer zu befreien. Dazu werden ca. 12g Probe mit 200 g Aceton für 6 h via Soxhlet-Extraktion bei 56 °C aufgereinigt. Anschließend wird für 2 h bei 70°C unter Vakuum getrocknet (ca. 100 mbar). Von den gereinigten Proben werden 10%ige Lösung in n-Propanol/Wasser (w%, n-Propanol = 50%) hergestellt, wobei der exakte Feststoffgehalt notiert wird. 5 g dieser Lösung werden mit 2 g Kalilauge (aq. 2 mol/L) in ein 50 mL Gefäß eingewogen Die Proben werden für 4 h bei 93°C in einen Trockenschrank gestellt und temperiert. Zum Neutralisieren werden 3 g Salzsäure (2 mol/L) eingewogen. Anschließend werden die Proben für 45 min auf einem IKA 130 Basic Rüttler (IKA) mit 450 U/min geschüttelt. Die Kappe wird entfernt und 35 g Aceton mit Decanol als internem Standard (1500 g Aceton/ 0,51 g 1-Decanol) eingewogen. Die Proben werden für 1,5 h auf einem IKA 130 Basic Rüttler (IKA) mit 450 U/min gemischt. Diese Lösung wird über einen 0,25 µm Spritzenvorsatzfilter in 2 mL GC Vials für die Flüssiginjektion abgefüllt. Diese werden in den Autosampler gestellt und mit einem TRACE 1300 GC mit TriPlus 100LS Gaschromatografen (Thermo Fisher Scientific) mittels der Software Chromeleon (Version 7.2.) analysiert, wobei die Ausgabe an Methacrylsäure (MAS) und Essigsäure (Essig) in mg/g erfolgt. Dabei werden eine FFAP Säule (Chromatographie Service GmbH) mit einer Länge von 50 m, einer Belegung von 0,25 mm bei 220°C und 175 kPa, ein FID Detektor und Wasserstoff (6.0, Air Liquide) als Trägergas verwendet.

Die Auswertung der Ergebnisse erfolgt unter der Annahme, dass die molare Menge der gegebenenfalls substituierten Acrylsäure und der Essigsäure den molaren Mengen der im Polymer vorhandenen Vinylacrylat- bzw. Vinylacetat-Einheiten entspricht und sich die molaren Anteile an Vinylalkohol-, Vinylacrylat- bzw. Vinylacetat-Einheiten zu 100% addieren. Dies wird im Folgenden am Beispiel von Vinylmethacrylat veranschaulicht. Die Werte der Methacrylsäure (mg/g) und der Essigsäure (mg/g) aus der GC Analyse werden auf die Gesamtlösung des eingewogenen funkt. Polymers (in g) umgerechnet, wobei die Stoffmassen $m_{MAS}$ und $m_{Essig}$ in g erhalten werden. Die Berechnung der molaren Massen erfolgt nach:

$$n_{MAS} = \frac{m_{MAS}}{M_{MAS}} \quad \text{und} \quad n_{Essig} = \frac{m_{Essig}}{M_{Essig}} \text{ und damit}$$

$$n_{Vinylalkohol} = \frac{(m_{funkt.PVA} - (n_{Vinylacetat} \times M_{Vinylacetat}) - (n_{Vinylmethacrylat} \times M_{Vinylmethacrylat})}{M_{Vinylalkohol}}$$

mit

$$M_{Vinylacetat} = 86\ \frac{g}{mol} \qquad M_{Vinylmethacrylat} = 112\ \frac{g}{mol} \qquad M_{Vinylalkohol} = 44\ \frac{g}{mol}$$

ergibt sich für den Funktionalisierungsgrad in %:

$$\text{Funktionalisierungsgrad [\%]} = \frac{n_{Vinylmethacrylat} \times 100}{n_{Vinylmethacrylat} + n_{Vinylacetat} + n_{Vinylalkohol}}$$

Zug-Dehnungs-Messungen

Die Zugdehnungsmessungen werden an belichteten, gewaschenen und getrockneten Proben (ohne Deck- und Trägerfolie, welche zuvor abgezogen wurden) durchgeführt, wobei die Gesamtdicke der Platte verwendet wird (also die Belichtung von der Vorderseite ohne Strukturierung durchgeführt wird). Die Belichtungs-, Auswasch- und Trocknungsbedingungen sind bei den jeweiligen Versuchen angegeben. Nach dem Trocknen wurden die Platten über Nacht bei Raumtemperatur gelagert und mittels einer Zwickprobenform 5A (von Zwick Roell AG) jeweils 4 Messproben mit einer Messlänge von 20 mm und einer Messbreite von 4 mm herausgestanzt. Dabei ist darauf zu achten, dass keine Beschädigungen (Risse etc.) und/oder Fremdkörper (z.B. Luftblasen, Partikel etc.) in den Proben vorhanden sind. Die Messungen wurden mit einem Zwick Roell 72.5 Gerät (von Zwick Roell AG) mit der Software testexpert V10.0 Version in Anlehnung an DIN 53504 mit einer Vorkraft von 0,01 MPa und einer Dehnungsgeschwindigkeit von 100 mm/min bei Raumtemperatur durchgeführt. Es werden jeweils 4 Proben vermessen und die arithmetischen Mittel der Reißdehnung $\varepsilon R$ in % sowie der Streckspannung $\sigma_{max}$ in $N/mm^2$ angegeben.

Viskositätsmessungen für die teilverseiften Polyvinylacetate

Messungen der Viskosität erfolgten mit einem Kugelfall-Viskosimeter nach DIN 53 015 an einer 4%igen wässrigen Lösung bei 20 °C.

Viskositätsmessung für die strahlungsempfindlichen Gemische

Die Messungen der Viskosität erfolgten mit einem Rotationsviskosimeter HAAKE Viscotester 550 mit Messbecher MV nach DIN 53019 bei 60 °C bei einer Drehzahl von 64 Umdrehungen/min

Bestimmung der Belichtungszeit

Zur Bestimmung der Belichtungszeit wurden Platten nach dem Abziehen der Schutzfolie mittels eines nyloprint® Combi CW 35 x 50 (Flint Group), ausgerüstet mit TL 09 Röhren, und durch ein Testnegativ (Reprofilm, Köstlin, 1C Testform nyloprint konventionell, 2540 dpi, 45° Winkelung) mit unterschiedliche Zeiten belichtet. Nach dem Auswaschen mit einem nyloprint® Combi CW 35 x 50 (Flint Group) und unter der Verwendung von Wasser und anschließendem Trocknen bei 65°C für 10 Minuten wurde die Belichtungszeit bestimmt, bei der der 2% Raster (59 L/cm) fehlerfrei ausgebildet ist.

Bestimmung der Auswaschzeit

Zur Bestimmung der Auswaschzeit wurden unbelichtete Platten so lange in einem nyloprint® Combi CW 35 x 50 (Flint Group) und unter der Verwendung von Wasser so lange gewaschen, bis die photoempfindliche Schicht vollständig entfernt war. Die dafür nötige Zeit wird als Auswaschzeit in Minuten angegeben.

Trocknung

Die gewaschenen Platten wurden für 10 Minuten bei 65°C in einem nyloprint® Combi CW 35 x 50 (Flint Group)Trockner getrocknet.

Curling-Messungen

Zur Bestimmung des Curlings wurden 20 x 20 cm große Platten nach dem Abziehen der Schutzschicht mittels eines nyloprint® Combi CW 35 x 50 (Flint Group), ausgerüstet mit TL 09 Röhren, für die entsprechende Zeit zur Ausbildung des 2% Rasters (59 L/cm) Minuten belichtet (ohne Negativ) und entwickelt (entsprechende Auswaschzeit mit Wasser für die jeweilige Platte) und getrocknet. Anschließend wurden die Platten bei Raumtemperatur für 3 Tage gelagert. Dabei bogen sich die 4 Ecken der Platten von der Unterlage weg nach oben. An den 2 Ecken mit den höchsten Werten wurde der Abstand der Ecke von der Unterlage in Millimetern vermessen und das arithmetische Mittel dieser 2 Messwerte gebildet und angegeben.

Bewertung der Druckergebnisse im Hinblick auf die Hochlichter

Weiterhin wurde ein Druckversuch mit einer UV-Buchdruckfarbe, UVONOVA (Flint Group), durchgeführt. Hierzu wurden die Druckplatten auf einen Druckzylinder aufgespannt und auf einem üblichen Buchdruckwerk (Druckmaschine: Nilpeter-F 2400) verdruckt. Der Bedruckstoff war einseitig Gussgestrichenes Papier "High Gloss White Premium" von Avery Dennison. Die Druckgeschwindigkeit betrug 25 m/min. Die Weite des Rasters betrug 59 Linien/cm. Gemessen wurde die Tonwertzunahme (1% bis 10% Rasterfeld) der Druckkennlinien bezüglich der idealen Tonwertvorlage (1:1 Kurve). Die Ergebnisse des Druckversuches sind in Tabelle 4-5 und 6 zusammengestellt. Nach dem Drucken wurden die Druckplatten visuell auf Risse in den Vollflächen untersucht.

Beispiel 1: Herstellung von Polymer P1 mit 1,0 mol-% Funktionalisierungsgrad

In einem Gefäß wird unter guter Durchmischung mittels eines leistungsstarken Rührers zu 82,5 Gewichtsteilen eines Polyvinylacetatgranulats (Verseifungsgrad 82%, Viskosität: 5 mPas) eine Mischung aus 6,6 Gewichtsteilen Propylencarbonat, 6,6 Gewichtsteilen Ethylencarbonat, 3,3 Gewichtsteilen Methacrylsäureanhydrid (VISIOMER MAAH, Fa. Evonik Industries, 94% Qualität), 0,9 Gewichtsteilen eines Veresterungskatalysators (N.-Methylimidazol) und 0,1 Gewichtsteilen 2,6-Di-t-butyl-kresol als thermischen Stabilisator (Kerobit® TBK der Fa. BASF, Deutschland) gegeben. Die Mischung wird anschließend bei einer Temperatur von 85° C 5 Stunden gerührt. Nach dieser Zeit erhält man ein rieselfähiges Granulat, das aus einem teilverseiften, nachträglich polymeranalog funktionalisierten Polyvinylacetat, den Quellungsmitteln, Katalysator, Stabilisator und Methacrylsäure besteht.
Nach der oben beschriebenen Methode (analog zu EP0962828A1) wurde ein Copolymer mit 1,0 mol-% Vinylmethacrylsäureeinheiten, 84,8 mol-% Vinylalkoholeinheiten und 14,2 mol-% Vinylacetateinheiten erhalten.

Beispiel 2: Herstellung von Polymer P2 mit 1,1 mol-% Funktionalisierungsgrad

Analog zu Beispiel 1 wurde ein Copolymer hergestellt ausgehend von einem teilverseiften Polyvinylacetat mit einem Hydrolysegrad von 88% und einer Viskosität von 3 mPas. Als Ergebnis wurde ein Copolymer mit 1,1 mol-% Vinylmethacrylsäureeinheiten, 86,2 mol-% Vinylalkoholeinheiten und 12,7 mol-% Vinylacetateinheiten erhalten.

Beispiel 3: Herstellung von Polymer P3 mit 1,9 mol-% Funktionalisierungsgrad

Analog zu Beispiel 1 wurde ausgehend von einem teilverseiften Polyvinylacetat (Verseifungsgrad 82%, Viskosität: 5 mPas) ein Copolymer mit 1,9 mol-% Vinylmethacrylsäureeinheiten, 83,9 mol-% Vinylalkoholeinheiten und 14,2 mol-% Vinylacetateinheiten erhalten.

Beispiel 4: Herstellung von Polymer P4 mit 0,57 mol-% Funktionalisierungsgrad

Analog zu Beispiel 1 wurde ausgehend von einem teilverseiften Polyvinylacetat (Verseifungsgrad 82%, Viskosität: 5 mPas) ein Copolymer mit 0,57 mol-% Vinylmethacrylsäureeinheiten, 82,4 mol-% Vinylalkoholeinheiten und 17,03 mol-% Vinylacetateinheiten erhalten.

Vergleichsbeispiel 5: Herstellung von Polymer P5 mit 3,4 mol-% Funktionalisierungsgrad

Die Herstellung des funktionalisierten Polyvinylacetats erfolgte gemäß DE-A 33 22 994. Dazu wurden 50 Gewichtsteile eines teilverseiften Polyvinylacetats (Verseifungsgrad 82 mol-%, mittleres Molekulargewicht 30 000 g/mol) in 150 Gewichtsteilen Toluol aufgeschlämmt und dann mit 8 Gewichtsteilen Methacrylsäureanhydrid, 0,4 Gewichtsteilen Methylimidazol und 0,05 Gewichtsteilen Kerobit TBK versetzt. Das inhomogene Reaktionsgemisch wurde 5 h bei 85° C gerührt, danach das Umsetzungsprodukt abgetrennt, mit Toluol gewaschen und bei 50° C 12 Stunden im Trockenschrank getrocknet. Es wurde ein Copolymer mit 3,4 mol-% Vinyl(Meth)acrylsäureeinheiten, 81,0 mol-% Vinylalkoholeinheiten und 15,6 mol-% Vinylacetateinheiten erhalten.

Tabelle 1: Übersicht über die teilverseiften, funktionalisierten Polyvinylacetate P1 bis P4

| | Beispiel 1 P1 | Beispiel 2 P2 | Beispiel 3 P3 | Beispiel 4 P4 | Vergleichsbeispiel P5 |
|---|---|---|---|---|---|
| Vinyl(Meth)Acrylsäure-Einheiten (mol-%) | 1,0 | 1,1 | 1,9 | 0,57 | 3,4 |
| Vinylalkohol-Einheiten (mol-%) | 84,8 | 86,2 | 83,9 | 82,4 | 81,0 |
| Vinylacetat-Einheiten (mol-%) | 14,2 | 12,7 | 14,2 | 17,03 | 15,6 |

Druckplattenvorläufer:

Zur Herstellung von photopolymerisierbaren Druckformen wird mit den gemäß Beispiel 1 bis 5 erhaltenen Copolymeren und den andern Bestandteilen folgendermaßen verfahren:
Entsprechende Gewichtsteile (siehe folgende Beispiele) eines teilverseiften, nachträglich polymeranalog funktionalisierten Polyvinylacetats (beschrieben in Beispiel 1 bis 5) und eines Polyvinylalkohol/Polyethylenglykol-Graft-Copolymeres, das durch Pfropfen von Vinylacetat auf Polyethylenglykol mit Molekulargewichten zwischen 1 000 und 50 000 und anschließender Verseifung bis zu einem Verseifungsgrad zwischen 80 und 100 % erhältlich sind (beispielsweise beschrieben in DE 2846647A1), wurden in einem Gemisch aus 276 Gewichtsteilen Wasser und 184 Gewichtsteile n-Propanol bei einer Temperatur von 85°C gelöst und gerührt, bis eine homogene Lösung entstanden ist. Anschließend wurden als ethylenisch ungesättigte Verbindung entsprechende Gewichtsteile eines Phenylglycidyletheracrylats (2-Hydroxy-3-phenoxypropylacrylat) und als Initiator 1,5 Gewichtsteile Benzildimethylketal, als thermischer Inhibitor 0,3 Gewichtsteile des Kaliumsalzes des N-Nitrosocyclohexalhydroxylamins sowie als Farbstoff 0,01 Gewichtsteile Safranin T (C.I. 50240) und 0,01 Gewichtsteile Acriflavin (C.I. 46000) zugegeben und bei einer Temperatur von 85°C gerührt, bis eine homogene Lösung entstanden ist. Diese Lösung wurde anschließend auf einen Folienträger in der Art und Weise vergossen, dass sich nach dem Trocknen eine 600 μm dicke lichtempfindliche Schicht ergab. Dieses Material wurde auf eine beschichtete PET-Folie kaschiert und die so erhaltene Schicht mit einer Gesamtdicke von 1050 μm für drei Stunden bei 60°C in einem Trockenschrank getrocknet.

Die konventionelle Herstellung von Druckklischees erfolgt unter Benutzung eines fotografischen Negativs. Dazu wird zuerst die Schutzfolie der Druckplatte abgezogen und nun die lichtempfindliche Schicht durch ein Testnegativ in einem UV-Vakuumbelichter (nyloprint® Combi CW 35 x 50, Flint Group) belichtet und mit Wasser ausgewaschen (siehe Bestimmung der Auswaschzeit), getrocknet und nachbehandelt.

Beispiel 6: Gemisch enthaltend Polymer P1 mit 1,0 mol-% Funktionalisierungsgrad mit Wasserstoffbrücken bildendem Additiv (Polyol/Polyether Graft-Copolymer)

Eine photopolymerisierbare Formulierung bestehend aus:

45 Gewichtsteilen des in Beispiel 1 hergestellten funktionalisierten Copolymers P1,
20 Gewichtsteile eines Polyvinylalkohol/Polyethylenglykol-Graft-Copolymeres mit einem Hydrolysegrad von 97% und einer Viskosität von 5 mPas
33,18 Gewichtsteile Phenylglycidyletheracrylat,
1,5 Gewichtsteile Benzildimethylketal,
0,3 Gewichtsteile N-Nitroso-cyclohexylhydroxylamin, Kaliumsalz,0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet. Die gemessene Viskosität beim Auftragen betrug 3500 mPas (60°C).

Beispiel 7: Gemisch enthaltend Polymer P1 mit 1,0 mol-% Funktionalisierungsgrad und Wasserstoffbrücken bildendes Additiv (Polyol/Polyether Graft-Copolymer)

Eine photopolymerisierbare Formulierung bestehend aus:

45 Gewichtsteile des in Beispiel 1 hergestellten funktionalisierten Copolymers P1
20 Gewichtsteile eines Polyvinylalkohol/Polyethylenglykol-Graft-Copolymeres mit einem Hydrolysegrad von 86% und einer Viskosität von 4 mPas
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Beispiel 8: Gemisch enthaltend Polymer P2 mit 1,1 mol-% Funktionalisierungsgrad und Wasserstoffbrücken bildendes Additiv (Polyol/Polyether Graft-Copolymer)

Eine photopolymerisierbare Formulierung bestehend aus:

55 Gewichtsteile des in Beispiel 2 hergestellten funktionalisierten Copolymers P2
10 Gewichtsteile eines Polyvinylalkohol/Polyethylenglykol-Graft-Copolymers mit einem Hydrolysegrad von 86% und einer Viskosität von 4 mPas

33,18 Gewichtsteile Phenylglycidyletheracrylats
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Beispiel 9: Gemisch enthaltend Polymer P3 mit 1,9 mol-% Funktionalisierungsgrad und Wasserstoffbrücken bildendes Additiv (Polyol/Polyether Graft-Copolymer)

Eine photopolymerisierbare Formulierung bestehend aus:

45 Gewichtsteile des in Beispiel 3 hergestellten funktionalisierten Copolymers P3
20 Gewichtsteile eines Polyvinylalkohol/Polyethylenglykol-Graft-Copolymeres mit einem Hydrolysegrad von 97% und einer Viskosität von 5 mPas
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet. Die gemessene Viskosität beim Auftragen betrug 4770 mPas (60°C).

Beispiel 10: Gemisch enthaltend Polymer P3 mit 1,9 mol-% Funktionalisierungsgrad und Wasserstoffbrücken bildendes Additiv (Polyamin)

Eine photopolymerisierbare Formulierung bestehend aus:

45,17 Gewichtsteile des in Beispiel 3 hergestellten funktionalisierten Copolymers P3
17,5 Gewichtsteile eines Polyvinylalkohol/Polyethylenglykol-Graft-Copolymeres mit einem Hydrolysegrad von 97% und einer Viskosität von 5 mPas
2,5 Gewichtsteile eines Polyethylenimin (Polyamins) mit einem Molekular Gewicht von (GPC) ca. 25000 g/mol, einer Viskosität (50°C, DIN 53015) ca. 15500 mPas und einen pH Wert von ca. 13
33 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Orasol Blau (C.I. Solvent Blue 70),
0,02 Gewichtsteile Acriflavin (C.I. 46000),

wurde wie oben beschrieben hergestellt und zu einem Druckvorläufer verarbeitet. Die gemessene Viskosität beim Auftragen betrug 4310 mPas (60°C).

Beispiel 11: Gemisch enthaltend Polymer P3 mit 1,9 mol-% Funktionalisierungsgrad und Wasserstoffbrücken bildendes Additiv (Polyamin)

Eine photopolymerisierbare Formulierung bestehend aus:

45,17 Gewichtsteile des in Beispiel 3 hergestellten funktionalisierten Copolymers P3
17,5 Gewichtsteile eines Polyvinylalkohol/Polyethylenglykol-Graft-Copolymeres mit einem Hydrolysegrad von 97% und einer Viskosität von 5 mPas
2,5 Gewichtsteile einer 50% wässrigen Lösung eines Polyethylenimin's (Polyamin, Kationisch) mit einer Viskosität (20°C, ISO 2431, Nr. 4,) ca. 100 mPas und einen pH Wert von ca. 11
33 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Orasol Blau (C.I. Solvent Blue 70),

0,02 Gewichtsteile Acriflavin (C.I. 46000),

wurde wie oben beschrieben hergestellt und zu einem Druckvorläufer verarbeitet. Die gemessene Viskosität beim Auftragen betrug 3920 mPas (60°C).

Beispiel 12: Gemisch enthaltend Polymer P3 mit 1,9 mol-% Funktionalisierungsgrad und Wasserstoffbrücken bildendes Additiv (Polyurethan)

Eine photopolymerisierbare Formulierung bestehend aus:

43 Gewichtsteile des in Beispiel 3 hergestellten funktionalisierten Copolymers P3
20 Gewichtsteile eines Polyvinylalkohol/Polyethylenglykol-Graft-Copolymeres mit einem Hydrolysegrad von 97% und einer Viskosität von 5 mPas
2,0 Gewichtsteile eines Polyurethanacrylats PUA BIN 200 (BASF)
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet. Die gemessene Viskosität beim Auftragen betrug 4670 mPas (60°C).

Beispiel 13: Gemisch enthaltend Polymer P3 mit 1,9 mol-% Funktionalisierungsgrad und Wasserstoffbrücken bildendes Additiv (Polyol)

Eine photopolymerisierbare Formulierung bestehend aus:

45 Gewichtsteile des in Beispiel 3 hergestellten funktionalisierten Copolymers P3
20 Gewichtsteile eines Polyvinylalkohol/Polyethylenglykol-Graft-Copolymeres mit einem Hydrolysegrad von 97% und einer Viskosität von 5 mPas
6,5 Gewichtsteile Glycerin,
33,17 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,02 Gewichtsteile Orasol Blau (C.I. Solvent Blue 70),
0,01 Gewichtsteile Acriflavin (C.I. 46000),

wurde wie oben beschrieben hergestellt und zu einem Druckvorläufer verarbeitet. Die gemessene Viskosität beim Auftragen betrug 3990 mPas (60°C).

Beispiel 14: Gemisch enthaltend Polymer P3 mit 1,9 mol-% Funktionalisierungsgrad und Wasserstoffbrücken bildendes Additiv (Polyether)

Eine photopolymerisierbare Formulierung bestehend aus:

45 Gewichtsteile des in Beispiel 3 hergestellten funktionalisierten Copolymers P3
20 Gewichtsteile eines PEG 400 Polymeres (Polyethylenglykol)
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet. Die gemessene Viskosität beim Auftragen betrug 4340 mPas (60°C).

Beispiel 15: Gemisch enthaltend Polymer P5 mit 3,4 mol-% Funktionalisierungsgrad und Wasserstoffbrücken bildendes Additiv (Polyol/Polyether Graft-Copolymer)

Eine photopolymerisierbare Formulierung bestehend aus:

45 Gewichtsteile des in Beispiel 5 hergestellten funktionalisierten Copolymers P5
20 Gewichtsteile eines Polyvinylalkohol/Polyethylenglykol-Graft-Copolymeres mit einem Hydrolysegrad von 97% und einer Viskosität von 5 mPas
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Vergleichsbeispiel 16: Gemisch enthaltend Polymer P5 mit 3,4 mol-% Funktionalisierungsgrad und Wasserstoffbrücken bildendes Additiv (Polyol/Polyether Graft-Copolymer)

Eine photopolymerisierbare Formulierung bestehend aus:

24 Gewichtsteile des in Beispiel 5 hergestellten funktionalisierten Copolymers P5
24 Gewichtsteile eines Polyvinylalkohol/Polyethylenglykol-Graft-Copolymeres mit einem Hydrolysegrad von 97% und einer Viskosität von 5 mPas
21,84 Gewichtsteile teilverseiftes Polyvinylacetat (Hydrolysegrad 88%, Viskosität von 3 mPas) 28 Gewichtsteile Phenylglycidyletheracrylats,
1,5 Gewichtsteile Benzildimethylketal,
0,4 Gewichtsteile N-Nitroso-cyclohexylhydroxylamin, Kaliumsalz,
0,01 Gewichtsteile Safranin T (C.I. 50240),
0,25 Gewichtsteile BYK 370 (Fa. BYK- Chemie GmbH),

wurde wie oben beschrieben hergestellt und zu einem Druckvorläufer verarbeitet. Die gemessene Viskosität beim Auftragen betrug 7500 mPas (60°C).

Beispiele ohne Wasserstoffbrücken bildendes Additiv (Polyol/Polyether Graft-Copolymer)

Beispiel 17: Gemisch enthaltend Polymer mit P1 mit 1,0 mol-% Funktionalisierungsgrad

Eine photopolymerisierbare Formulierung bestehend aus:

65 Gewichtsteile des in Beispiel 1 hergestellten funktionalisierten Copolymers P1
33,18 Gewichtsteile Phenylglycidyletheracrylats
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Beispiel 18: Gemisch enthaltend Polymer P3 mit 1,9 mol-% Funktionalisierungsgrad

Eine photopolymerisierbare Formulierung bestehend aus:

65 Gewichtsteile des in Beispiel 3 hergestellten funktionalisierten Copolymers P3
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),

0,01 Gewichtsteile Acriflavin (C.I. 46000),

wurde wie oben beschrieben hergestellt und zu einem Druckvorläufer verarbeitet.

Vergleichsbeispiel 19: Gemisch enthaltend Polymer P5 mit 3,4 mol-% Funktionalisierungsgrad

Eine photopolymerisierbare Formulierung bestehend aus:

65 Gewichtsteile des in Beispiel 5 hergestellten funktionalisierten Copolymers P5
33,18 Gewichtsteile Phenylglycidyletheracrylats,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Beispiel 20: Gemisch enthaltend Polyvinylalkohol ohne Funktionalisierung

Eine photopolymerisierbare Formulierung bestehend aus:

65 Gewichtsteile teilverseiftes Polyvinylacetat (Hydrolysegrad 82%, Viskosität von 5 mPas),
33,18 Gewichtsteile Phenylglycidyletheracrylat,
1,5 Gewichtsteile Benzildimethylketal,
0,3 Gewichtsteile N-Nitroso-cyclohexylhydroxylamin, Kaliumsalz,
0,01 Gewichtsteile Safranin T (C.I. 50240),
0,01 Gewichtsteile Acriflavin (C.I. 46000),

wurde wie oben beschrieben hergestellt und zu einem Druckvorläufer verarbeitet.

Tabelle 2a: Photopolymerisierbare Formulierungen mit Wasserstoffbrücken bildendem Additiv normiert auf Vergleichsbeispiel 16

| | Beispiel 6 | Beispiel 7 | Beispiel 8 | Beispiel 9 | Vergleichs beispiel 15 | Vergleichs -beispiel 16 |
|---|---|---|---|---|---|---|
| Vinyl(Meth)Acrylsäure-Einheiten (mol-%) | 1,0 | 1,0 | 1,1 | 1,9 | 3,4 | 3,4 |
| Vinylalkohol-Einheiten (mol-%) | 84,8 | 84,8 | 86,2 | 83,9 | 81,0 | 81,0 |
| Vinylacetat-Einheiten (mol-%) | 14,2 | 14,2 | 12,7 | 14,2 | 15,6 | 15,6 |
| Additiv Graft-Copolymer (Gew%) | 20 | 20 | 10 | 20 | 20 | 24 |
| Additiv | Polyol | Polyol | Polyol | Polyol | Polyol | Polyol |
| Curling * | 0,42 | 0,5 | 0,64 | 0,13 | 1,10 | 1,00 |
| Belichtungszeit * | 1,00 | 0,86 | 1,43 | 0,86 | 0,86 | 1,00 |
| Waschzeit * | 0,88 | 1,00 | 0,63 | 0,88 | 1,00 | 1,00 |
| Qualität nach Waschen | gut | gut | befr. | sehr gut | gut | gut |
| Zwischentiefe * | 1,29 | 1,19 | 1,00 | 1,52 | 1,38 | 1,00 |
| Druckverhalten | gut | gut | - | sehr gut | befr. | befr. |
| $\delta_{max}$* | 0,41 | 0,46 | - | 0,51 | 0,74 | 1,00 |

(fortgesetzt)

| | Beispiel 6 | Beispiel 7 | Beispiel 8 | Beispiel 9 | Vergleichs beispiel 15 | Vergleichs -beispiel 16 |
|---|---|---|---|---|---|---|
| εR * | 1,70 | 1,80 | - | 1,19 | 0,81 | 1,00 |
| * Normiert auf Vergleichsbeispiel 16 | | | | | | |

Wie aus Tabelle 2a ersichtlich ist, zeigen alle Beispiele 6 bis 9 ein geringeres Curling, gleiche oder geringere Belichtungs- und Waschzeiten, größere Zwischentiefen, besseres Druckverhalten, niedrigere Streckspannung und damit höhere Elastizität und höhere Reißfestigkeit.

Tabelle 2b: Photopolymerisierbare Formulierungen mit Wasserstoffbrücken bildendem Additiv, normiert auf Vergleichsbeispiel 16

| | Beispiel 10 | Beispiel 11 | Beispiel 12 | Beispiel 13 | Beispiel 14 | Vergleichs -beispiel 16 |
|---|---|---|---|---|---|---|
| Vinyl(Meth)Acrylsäure-Einheiten (mol-%) | 1,9 | 1,9 | 1,9 | 1,9 | 1,9 | 3,4 |
| Vinylalkohol-Einheiten (mol-%) | 83,9 | 83,9 | 83,9 | 83,9 | 83,9 | 81,0 |
| Vinylacetat-Einheiten (mol-%) | 14,2 | 14,2 | 14,2 | 14,2 | 14,2 | 15,6 |
| Summe Additive (Gew%) | 20 | 20 | 22 | 26,5 | 20 | 24 |
| Additiv | Polyamin, Polyol | Polyamin, Polyol | Polyol, Polyamid | Polyol | Polyol | Polyol |
| Curling * | 0,25 | 0,22 | 0,21 | 0,13 | 0,17 | 1,00 |
| Belichtungszeit * | 1,00 | 1,14 | 1,14 | 1,43 | 1,00 | 1,00 |
| Waschzeit * | 1,00 | 1,25 | 1,13 | 0,75 | 1,00 | 1,00 |
| Qualität nach Waschen | gut | gut | gut | gut | befr. | gut |
| Zwischentiefe * | 1,04 | 0,93 | 1,13 | 1,28 | 1,41 | 1,00 |
| Druckverhalten | gut | gut | gut | gut | befr. | befr. |
| $\delta_{max}$* | - | 0,34 | 0,50 | - | - | 1,00 |
| εR * | - | 0,81 | 1,02 | - | - | 1,00 |
| * Normiert auf Vergleichsbeispiel 16 | | | | | | |

Wie aus Tabelle 2b ersichtlich ist, zeigen alle Beispiele 10 bis 14 ein geringeres Curling, gleiche oder geringere Belichtungs- und Waschzeiten, größere Zwischentiefen, besseres Druckverhalten, niedrigere Streckspannung und damit höhere Elastizität und höhere Reißfestigkeit.

Tabelle 3: Photopolymerisierbare Formulierung ohne Wasserstoffbrücken bildendes Additiv, normiert auf Vergleichsbeispiel 16

| | Vergleichsbeispiel17 | Vergleichsbeispiel18 | Vergleichsbeispiel 19 | Vergleichsbeispiel 20 | Vergleichsbeispiel 16 |
|---|---|---|---|---|---|
| Vinyl(Meth)Acrylsäure-Einheiten (mol-%) | 1,0 | 1,9 | 3,4 | 0 | 3,4 |
| Vinylalkohol-Einheiten (mol-%) | 84,8 | 83,9 | 81,0 | 18,0 | 81,0 |
| Vinylacetat-Einheiten (mol-%) | 14,2 | 14,2 | 15,6 | 82,0 | 15,6 |
| Curling * | 0,29 | 0,14 | 1,18 | nm | 1,00 |
| Belichtungszeit * | 0,86 | 1,00 | 1,14 | > 1,43[§] | 1,00 |
| Waschzeit * | 1,38 | 1,50 | 1,63 | 0,88 | 1,00 |
| Qualität nach Waschen | gut | gut | befr. | sehr schlecht | gut |
| Zwischentiefe * | 1,45 | 1,17 | 1,36 | nm | 1,00 |
| Druckverhalten | gut | gut | befr. | nm | befr. |
| $\delta_{max}$ * | 0,72 | 0,52 | 1,21 | 0,4 | 1,00 |
| $\varepsilon R$ * | 0,97 | 0,80 | 0,61 | 1,95 | 1,00 |

* Normiert auf Vergleichsbeispiel 16
nm = nicht messbar
[$] Es wird kein stabiles Rasterfeld/Gitter ausgebildet

Wie aus Tabelle 3 ersichtlich ist, zeigen alle Beispiele 17 und 18 ein geringeres Curling, gleiche oder geringere Belichtungs- und Waschzeiten, größere Zwischentiefen, besseres Druckverhalten, niedrigere Streckspannung und damit höhere Elastizität und höhere Reißfestigkeit. Diese Beispiele 17 und 18 fallen nicht unter den Schutzumfang der gültigen Ansprüche. Nur Vergleichsbeispiel 20 ohne Funktionalisierung zeigt kein stabil ausgebildetes Rasterfeld (Abtragung durch die Bürsten beim auswaschen) und lässt deshalb auch die Messung weiterer Daten nicht zu.

Tabelle 4: Direkter Vergleich der photopolymerisierbare Formulierungen mit und ohne Wasserstoffbrücken bildenden Additiv

| | Beispiel 6 | Beispiel 7 | Vergleichsbeispiel 17 | Beispiel 9 | Vergleichsbeispiel 18 |
|---|---|---|---|---|---|
| Funkt. PVA | P1 | P1 | P1 | P3 | P3 |
| Wasserstoffbrücken Additiv | Polyether, Polyol | Polyether, Polyol | - | Polyether, Polyol | - |
| Curling * | 0,42 | 0,5 | 0,29 | 0,13 | 0,14 |
| Belichtungszeit * | 1,00 | 0,86 | 0,86 | 0,86 | 1,00 |
| Waschzeit * | 0,88 | 1,00 | 1,38 | 0,88 | 1,50 |
| Qualität nach Waschen | gut | gut | gut | sehr gut | gut |
| Zwischentiefe * | 1,29 | 1,19 | 1,45 | 1,52 | 1,17 |
| Druckverhalten | gut | gut | gut | sehr gut | gut |
| Rissbildung | rissfrei | wenig | mittel | rissfrei | wenig |
| $\delta_{max}$ * | 0,41 | 0,46 | 0,72 | 0,51 | 0,52 |
| $\varepsilon R$ * | 1,70 | 1,80 | 0,97 | 1,19 | 0,80 |
| * Normiert auf Vergleichsbeispiel 16 | | | | | |

Ein Vergleich der Ergebnisse (Tabelle 4) der Formulierungen mit P1 von Beispiel 6 und 7 (mit Wasserstoffbrücken bildenden Additiv) mit Beispiel 17 (ohne Additiv) und von Formulierungen von Beispiel 9 mit Beispiel 18 (ohne Additiv) ergibt, dass der Zusatz von Wasserstoffbrücken bildendem Additiv eine kürzere Auswaschzeit, weniger Rissbildung während dem Druck, niedrigere Streckspannung und damit höhere Elastizität sowie eine höhere Reißfestigkeit mit sich bringt.

Tabelle 5: Gemessene Tonwerte (Druckergebnisse) von analogen Platten der Beispiele 6 bis 16

| TW Vorlage | Beispiel 6 (P1) | Beispiel 7 (P1) | Beispiel 9 (P3) | Beispiel 15 (P5) | Vergleichsbeispiel 16 (P5) |
|---|---|---|---|---|---|
| 1,00% | - | 1,5% | 7,0% | - | 14,2% |
| 2,00% | 4,5% | 3,2% | 9,2% | 8,5% | 19,6% |
| 3,00% | 8% | 5,1% | 9,3% | 10% | 23,4% |
| 4,00% | 13,2% | 7% | 9,9% | 11,9% | 23,4% |
| 5,00% | 16,5% | 9,3% | 11,4% | 12,6% | 26,5% |
| 10,00% | 22,3% | 17,7% | 19,0% | 21,3% | 30,6% |

Tabelle 5 zeigt, dass insbesondere die kleinen Tonwerte besser gehalten werden und die Abweichungen zum Zielwert geringer sind.

Beispiel 21: Digitale Platten

Die Herstellung digitaler photopolymerisierbarer Druckformen erfolgt mit Polymeren gemäß Beispielen 1 bis 5 und daraus hergestellten photopolymerisierbaren Formulierungen gemäß Beispielen 6 bis 16 jedoch erfolgt das Aufbringen einer laserablatierbaren Maskenschicht, die aus einer Suspension bestehend aus 2 Teilen Ruß (Printex U von Orion Engineered Carbons GmbH) und 8 Teilen eines teilverseiften Polyvinylacetats (KP 5-88 von Kuraray) in 80 Teilen Wasser und 20 Teilen n-Propanol erhalten wurde.

Die Platten werden auf die Trommel eines IR-Lasers (ESKO CDI Spark 2530) montiert und gelasert. Das gelaserte Motiv entsprach dem Testnegativ der vorhergehenden Beispiele. Anschließend wurde in einem UV-Vakuumbelichter (nyloprint® Combi CW 35 x 50, Flint Group) belichtet und mit Wasser ausgewaschen, getrocknet und nachbehandelt.
Im Ergebnis verhielten sich die digitalen Platten mit laserablatierbarer Maskenschicht ähnlich wie die konventionellen Platten und zeigten im Vergleich zu den Vergleichsfomulierungen deutliche Verbesserungen (höhere Auflösung, geringeres Curling, gleiche oder geringere Belichtungs- und Waschzeiten, höhere Zwischentiefen, besseres Druckverhalten, höhere Elastizität und höhere Reißfestigkeit).

Tabelle 6: Gemessene Tonwerte (Druckergebnisse) von digitalen Platten der Beispiele 6, 9 und 16

| Tonwert Vorlage | Beispiel 6 | Beispiel 9 | Vergleichsbeispiel 16 |
|---|---|---|---|
| 1,00% | 2,4% | 2,4% | 2,4% |
| 2,00% | 4,0% | 3,9% | 5,5% |
| 3,00% | 6,1% | 4,7% | 6,9% |
| 4,00% | 7,6% | 6,2% | 7,0% |
| 5,00% | 9,8% | 8,4% | 9,2% |
| 10,00% | 20,0% | 15,5% | 15,5% |

Tabelle 6 zeigt, dass insbesondere die kleinen Tonwerte besser gehalten werden und die Abweichungen zum Zielwert geringer sind.

Beispiel 22: Lasergravur

Platten nach Beispiel 3, funktionalisierter PVA aus KP 5-82 mit 1,9 mol-% Funktionalisierungsgrad wurde wie oben beschrieben hergestellt und zu einem Druckvorläufer verarbeitet.
Eine photopolymerisierbare Formulierung bestehend aus:

58,78 Gewichtsteile des in Beispiel 3 hergestellten funktionalisierten Copolymers P3
33,4 Gewichtsteile Glycerindimethacrylat
5,2 Gewichtsteile Quarzmehl mit einer mittleren Korngröße von 3 $\mu$m
2,0 Gewichtsteile Benzildimethylketal
0,6 Gewichtsteile N-Nitroso-cyclohexylhydroxylamin, Kaliumsalz
0,01 Gewichtsteile Safranin T (C.I. 50240).
0,01 Gewichtsteile Acriflavin (C.I. 46000).

Die UV Belichtung erfolgte für 2,5 Minuten mittels eines nyloprint combi CW 35 x 50 Belichters. Die Platten wurden anschließend auf die Trommel eines $CO_2$-Lasers (Agrios, Stork Prints Austria GmbH) montiert und mit einer Auflösung von 2032 dpi gelasert. Das gelaserte Motiv umfasste verschiedene Rasterkeile, wobei die Auflösung des gewählten Rasters 60 L/cm betrug. Die Flächendeckung wurde von 70 bis 90% variiert. Als Flächendeckung wird im Tampondruck die prozentuale Fläche, die mittels Gravur entfernt wird, im Vergleich zur Gesamtfläche bezeichnet.
Die Leistung des Lasers betrug 500 Watt. Bei einer Umdrehungsgeschwindigkeit von 250 Umdrehungen pro Minute wurde die optimale Abbildungsschärfe erreicht.
Anschließend wurden die gravierten Klischees auf einer Tampondruckmaschine (Fa. Morlock, geschlossener Rakeltopf) montiert. Als Tampondruckfarbe wurde eine lösemittelbasierte Tampondruckfarbe Marabu TPY980 (Weiß) eingesetzt. Die Farbe enthält Kohlenwasserstoffe, Ketone und Acetate als Lösemittel. Als Härter wurde 10% Isocyanat-Härter H1 von Marabu zugesetzt. Beim Druck auf den Druckkörper konnten bei allen Klischees feine Elemente bis zu einer Flächendeckung von 90 % abgebildet werden.

**Patentansprüche**

**1.** Strahlungshärtbares Gemisch zur Erzeugung von Reliefstrukturen enthaltend

a) mindestens ein funktionalisiertes teilverseiftes Polyvinylacetat enthaltend (i) Vinylalkohol-, (ii) Vinylacetat-

und (iii) Vinylacrylat-Einheiten, wobei die Vinylacrylat-Einheiten substituiert sein können und die allgemeine Struktur

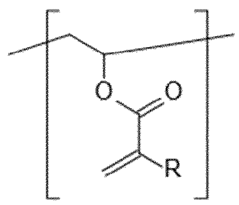

aufweisen, wobei R Wasserstoff oder ein linearer oder verzweigter aliphatischer oder heteroaliphatischer Rest mit 1 bis 12 C-Atomen oder ein cycloaliphatischer, heterocyclischer oder aromatischer Rest mit 3 bis 12 C-Atomen ist, als Komponente A,
b) mindestens einen Initiator als Komponente B,
c) mindestens eine von Komponente A verschiedene ethylenisch ungesättigte Verbindung als Komponente C,
d) ein oder mehrere Zusatzstoffe als Komponente D,

**dadurch gekennzeichnet, dass** der Gehalt an Vinylacrylat-Einheiten (iii) des funktionalisierten teilverseiften Polyvinylacetats a), bezogen auf alle Einheiten (i), (ii) und (iii), 0,1 bis < 3 mol-% beträgt und die Komponenten D ein zur Wasserstoffbrückenbildung fähiges Additiv in einer Menge von 1 bis 30 Gew.-%, bezogen auf die Summe der Komponenten A bis D, enthält.

**2.** Strahlungshärtbares Gemisch nach Anspruch 1, **dadurch gekennzeichnet, dass** der Gehalt an Vinylalkoholeinheiten (i) in Komponente A, bezogen auf alle Einheiten (i), (ii) und (iii), 65 bis 99 mol-% beträgt.

**3.** Strahlungshärtbares Gemisch nach Anspruch 1 oder 2, **dadurch gekennzeichnet, dass** der Gehalt von Vinylacetateinheiten (ii) in Komponente A, bezogen auf alle Einheiten (i), (ii) und (iii), 5 bis 35 mol-% beträgt.

**4.** Strahlungshärtbares Gemisch nach einem der Ansprüche 1 bis 3, **dadurch gekennzeichnet, dass** die Komponente A in einer Menge von 5 bis 75 Gew.-%, bezogen auf die Summe der Komponenten A bis D, enthalten ist.

**5.** Strahlungshärtbares Gemisch nach einem der Ansprüche 1 bis 4, **dadurch gekennzeichnet, dass** die Komponente B in einer Menge von 0,1 bis 20 Gew.-%, bezogen auf die Summe der Komponenten A bis D, enthalten ist.

**6.** Strahlungshärtbares Gemisch nach einem der Ansprüche 1 bis 5, **dadurch gekennzeichnet, dass** die ethylenisch ungesättigte Verbindung der Komponente C mindestens eine Vinylether- und/oder Acrylat- und/oder Methacrylatgruppe enthält.

**7.** Strahlungshärtbares Gemisch nach einem der Ansprüche 1 bis 6, **dadurch gekennzeichnet, dass** die Komponenten C in einer Menge von 0,5 bis 50 Gew.-%, bezogen auf die Summe der Komponenten A bis D, enthalten ist.

**8.** Strahlungshärtbares Gemisch nach einem der Ansprüche 1 bis 7, **dadurch gekennzeichnet, dass** die Additive ausgewählt sind aus der Gruppe bestehend aus Weichmachern, Lösungsmitteln, weiteren Bindemitteln, farbgebenden Mitteln, Stabilisatoren, Reglern, UV-Absorbern, Dispergierhilfsmitteln, nicht radikalisch vernetzenden Vernetzern, Viskositätsveränderern und Wasserstoffbrücken akzeptierenden Additiven.

**9.** Strahlungshärtbares Gemisch nach einem der Ansprüche 1 bis 8, **dadurch gekennzeichnet, dass** die Komponenten D in einer Menge von 1 bis 50 Gew.-%, bezogen auf die Summe der Komponenten A bis D, enthalten ist.

**10.** Strahlungshärtbares Gemisch nach einem der Ansprüche 1 bis 9, **dadurch gekennzeichnet, dass** das zur Wasserstoffbrückenbildung fähige Additiv ausgewählt ist aus der Gruppe bestehend aus Polyvinylalkohol, Polyvinylactetat, Polyethylenimin, Polyurethanen, Polyethylenglykol und Polyvinylakohol/Polyethylenglykol-Graft-Copolymer.

**11.** Strahlungshärtbares Mehrschichtelement, mindestens umfassend eine reliefbildende Schicht aus dem strahlungshärtbaren Gemisch gemäß einem der Ansprüche 1 bis 10 auf einem Träger.

**12.** Strahlungshärtbares Mehrschichtelement nach Anspruch 11, umfassend auf oder unter der reliefbildenden Schicht

mindestens eine weitere Schicht, ausgewählt aus der Gruppe bestehend aus einer Schutzschicht, einer Release-Schicht, einer Maskenschicht, einer Barriereschicht, einer Schicht zur Erzeugung einer Oberflächenstruktur und einer Haftschicht oder beliebigen Kombinationen davon.

**13.** Verfahren zur Herstellung eines Mehrschichtelements mit einer Reliefstruktur aus einem strahlungshärtbaren Mehrschichtelement gemäß Anspruch 11 oder 12, umfassend das Bestrahlen der reliefbildenden Schicht durch eine integrale oder aufbringbare Maskenschicht und das Entfernen der nicht gehärteten Bereiche der reliefbildenden Schicht.

**14.** Verfahren zur Herstellung eines Mehrschichtelements mit einer Reliefstruktur aus einem strahlungshärtbaren Mehrschichtelement gemäß Anspruch 11 oder 12, umfassend das Bestrahlen der reliefbildenden Schicht und das Eingravieren eines Reliefs in gehärtete Bereiche der reliefbildenden Schicht.

## Claims

**1.** Radiation-curable mixture for producing relief structures, containing

a) at least one functionalised, partially saponified polyvinyl acetate containing (i) vinyl alcohol units, (ii) vinyl acetate units and (iii) vinyl acrylate units, the vinyl acrylate units being substitutable and having the general structure

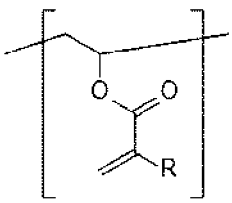

R being hydrogen or a linear or branched aliphatic or heteroaliphatic radical having 1 to 12 C atoms or a cycloaliphatic, heterocyclic or aromatic radical having 3 to 12 C atoms, as component A,
b) at least one initiator as component B,
c) at least one ethylenically unsaturated compound different from component A as component C,
d) one or more admixtures as component D,

**characterised in that** the content of vinyl acrylate units (iii) of the functionalised, partially saponified polyvinyl acetate a) based on all units (i), (ii) and (iii) is 0.1 to < 3 mol.%, and component D contains an additive capable of forming hydrogen bonds in an amount of 1 to 30 wt.% based on the sum of components A to D.

**2.** Radiation-curable mixture according to claim 1, **characterised in that** the content of vinyl alcohol units (i) in component A based on all units (i), (ii) and (iii) is 65 to 99 mol.%.

**3.** Radiation-curable mixture according to either claim 1 or claim 2, **characterised in that** the content of vinyl acetate units (ii) in component A based on all units (i), (ii) and (iii) is 5 to 35 mol.%.

**4.** Radiation-curable mixture according to any of claims 1 to 3, **characterised in that** component A is contained in an amount of 5 to 75 wt.% based on the sum of components A to D.

**5.** Radiation-curable mixture according to any of claims 1 to 4, **characterised in that** component B is contained in an amount of 0.1 to 20 wt.% based on the sum of components A to D.

**6.** Radiation-curable mixture according to any of claims 1 to 5, **characterised in that** the ethylenically unsaturated compound of component C contains at least one vinyl ether group and/or acrylate group and/or methacrylate group.

**7.** Radiation-curable mixture according to any of claims 1 to 6, **characterised in that** component C is contained in an amount of 0.5 to 50 wt.% based on the sum of components A to D.

8. Radiation-curable mixture according to any of claims 1 to 7, **characterised in that** the additives are selected from the group consisting of plasticisers, solvents, further binders, colouring agents, stabilisers, regulators, UV absorbers, dispersants, non-radical crosslinking agents, viscosity modifiers and hydrogen bond acceptor additives.

9. Radiation-curable mixture according to any of claims 1 to 8, **characterised in that** component D is contained in an amount of 1 to 50 wt.% based on the sum of components A to D.

10. Radiation-curable mixture according to any of claims 1 to 9, **characterised in that** the additive capable of forming hydrogen bonds is selected from the group consisting of polyvinyl alcohol, polyvinyl acetate, polyethyleneimine, polyurethanes, polyethylene glycol and polyvinyl alcohol/polyethylene glycol graft copolymer.

11. Radiation-curable multilayer element, at least comprising a relief-forming layer made of the radiation-curable mixture according to any of claims 1 to 10 on a substrate.

12. Radiation-curable multilayer element according to claim 11, comprising, on or underneath the relief-forming layer, at least one further layer selected from the group consisting of a protective layer, a release layer, a mask layer, a barrier layer, a layer for producing a surface structure and an adhesive layer, or any combinations thereof.

13. Method for producing a multilayer element comprising a relief structure made of a radiation-curable multilayer element according to either claim 11 or claim 12, comprising irradiation of the relief-forming layer through an integral or attachable mask layer and removal of the non-cured regions of the relief-forming layer.

14. Method for producing a multilayer element comprising a relief structure made of a radiation-curable multilayer element according to either claim 11 or claim 12, comprising irradiation of the relief-forming layer and engraving of a relief in cured regions of the relief-forming layer.

**Revendications**

1. Mélange durcissable sous l'effet d'un rayonnement, pour générer des structures en relief, contenant

a) au moins un polyacétate de vinyle partiellement saponifié fonctionnalisé contenant (i) des motifs d'alcool vinylique, (ii) des motifs d'acétate de vinyle et (iii) des motifs d'acrylate de vinyle, dans lequel les motifs d'acrylate de vinyle peuvent être substitués et présentent la structure générale

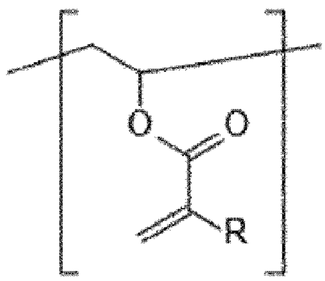

,

dans lequel R est de l'hydrogène ou un radical aliphatique ou hétéroaliphatique linéaire ou ramifié avec 1 à 12 atomes de C ou un radical cycloaliphatique, hétérocyclique ou aromatique avec 3 à 12 atomes de C, en tant que composant A,
b) au moins un initiateur en tant que composant B,
c) au moins un composé non saturé éthyléniquement, différent du composant A en tant que composant C,
d) un ou plusieurs additifs en tant que composant D,

**caractérisé en ce que** la teneur en motifs d'acrylate de vinyle (iii) du polyacétate de vinyle partiellement saponifié fonctionnalité a) va, par rapport à tous les motifs (i), (ii) et (iii) de 0,1 à < 3 % en mole et le composant D contient un additif capable de former une liaison hydrogène en une quantité de 1 à 30 % en poids, par rapport à la somme des composants A à D.

2. Mélange durcissable sous l'effet d'un rayonnement selon la revendication 1, **caractérisé en ce que** la teneur en motifs d'alcool vinylique (i) dans le composant A va, par rapport à tous les motifs (i), (ii) et (iii), de 65 à 99 % en mole.

3. Mélange durcissable sous l'effet d'un rayonnement selon la revendication 1 ou 2, **caractérisé en ce que** la teneur des motifs d'acétate de vinyle (ii) dans le composant A va, par rapport à tous les motifs (i), (ii) et (iii), de 5 à 35 % en mole.

4. Mélange durcissable sous l'effet d'un rayonnement selon l'une quelconque des revendications 1 à 3, **caractérisé en ce que** le composant A est contenu en une quantité de 5 à 75 % en poids, par rapport à la somme des composants A à D.

5. Mélange durcissable sous l'effet d'un rayonnement selon l'une quelconque des revendications 1 à 4, **caractérisé en ce que** le composant B est contenu en une quantité de 0,1 à 20 % en poids, par rapport à la somme des composants A à D.

6. Mélange durcissable sous l'effet d'un rayonnement selon l'une quelconque des revendications 1 à 5, **caractérisé en ce que** le composé insaturé éthyléniquement du composant C contient au moins un groupe d'éther vinylique, et/ou d'acrylate et/ou de méthacrylate.

7. Mélange durcissable sous l'effet d'un rayonnement selon l'une quelconque des revendications 1 à 6, **caractérisé en ce que** le composant C est contenu en une quantité de 0,5 à 50 % en poids, par rapport à la somme des composants A à D.

8. Mélange durcissable sous l'effet d'un rayonnement selon l'une quelconque des revendications 1 à 7, **caractérisé en ce que** les additifs sont choisis parmi le groupe constitué de plastifiants, de solvants, d'autres liants, d'agents colorants, de stabilisants, de régulateurs, d'absorbants d'UV, d'agents dispersants, d'agents de réticulation n'ayant pas une action de réticulation radicalaire, de modificateurs de rhéologie et d'additifs acceptant des liaisons hydrogène.

9. Mélange durcissable sous l'effet d'un rayonnement selon l'une quelconque des revendications 1 à 8, **caractérisé en ce que** le composant D est contenu en une quantité de 1 à 50 % en poids, par rapport à la somme des composants A à D.

10. Mélange durcissable selon l'une quelconque des revendications 1 à 9, **caractérisé en ce que** l'additif capable de former une liaison hydrogène est choisi parmi le groupe constitué d'alcool polyvinylique, de polyacétate de vinyle, de polyéthylène-imine, de polyuréthanes, de polyéthylène glycol et de copolymère greffé à base d'alcool polyvinylique et de polyéthylène glycol.

11. Élément multicouche durcissable sous l'effet d'un rayonnement, comprenant au moins une couche formant un relief composée d'un mélange durcissable sous l'effet d'un rayonnement selon l'une quelconque des revendications 1 à 10 sur un support.

12. Élément multicouche durcissable sous l'effet d'un rayonnement selon la revendication 11, comprenant, sur ou sous la couche formant un relief, au moins une autre couche choisie parmi le groupe constitué d'une couche de protection, d'une couche de séparation, d'une couche de masque, d'une couche formant barrière, d'une couche pour produire une structure superficielle et d'une couche adhésive ou de combinaisons quelconques de celles-ci.

13. Procédé de fabrication d'un élément multicouche avec une structure en relief composée d'un élément multicouche durcissable sous l'effet d'un rayonnement selon la revendication 11 ou 12, comprenant le rayonnement de la couche formant un relief à travers une couche de masque intégrale ou applicable et l'élimination des zones non durcies de la couche formant un relief.

14. Procédé de fabrication d'un élément multicouche avec une structure en relief composée d'un élément multicouche durcissable sous l'effet d'un rayonnement selon la revendication 11 ou 12, comprenant le rayonnement de la couche formant un relief et la gravure d'un relief dans des zones durcies de la couche formant un relief.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 3015419
- EP 0079514 A
- DE 3322993
- DE 3322994
- EP 849635 A
- EP 962828 A
- JP 4537377 B
- JP 4486516 B
- US 3567453 A
- US 4343891 A
- EP 109772 A
- EP 109773 A
- JP 63138345 B
- JP 63142345 B
- JP 63142346 B
- JP 63143537 B
- JP 4642363 B
- JP 59152396 B
- JP 61151197 B
- JP 6341484 B
- JP 2249 A
- JP 24705 A
- JP 626223 A
- JP 6314340 B
- JP 1559174831 B
- JP 1304453 A
- JP 1152109 A
- EP 0085472 A
- DE 1522444
- DE 3045516
- EP 0504824 A
- EP 0767406 A
- WO 9403839 A
- US 5262275 A
- WO 9403838 A
- DE 3045516 A1
- EP 0962828 A1
- DE 3322994 A
- DE 2846647 A1


### In der Beschreibung aufgeführte Nicht-Patentliteratur


- **BRUCE M. MONROE et al.** *Chemical Review,* 1993, vol. 93, 435
- **R. S. DAVIDSON.** *Journal of Photochemistry and Biology A: Chemistry,* 1993, vol. 73, 81
- **J. P. FAUSSIER.** Photoinitiated Polymerization-Theory and Applications: Rapra Review. *Report, RapraTechnology,* 1998, vol. 9
- **M. TSUNOOKA et al.** *25 Prog. Polym. Sci.,* 1996, vol. 21, 1
- **F. D. SAEVA.** *Topics in Current Chemistry,* 1990, vol. 1 56, 59
- **G. G. MASLAK.** *Topics in Current Chemistry,* 1993, vol. 168, 1
- **H. B. SHUSTER et al.** *JAGS,* 1990, vol. 112, 6329
- **I. D. F. EATON et al.** *JAGS,* 1980, vol. 102, 3298
- **P. FOUASSIER ; J. F. RABEK.** *Radiation Curing in Polymer Science and Technology,* 1993, 77-117
- Photoinitiators for free Radical and Cationic Polymerisation. **K.K. DIETLIKER.** Chemistry & Technology of UV & EB Formulation for Coatings, Inks and Paints. Sita Technology LTD, 1991, vol. 3
- **R.S. DAVIDSON.** Exploring the Science, Technology and Applications of U.V. and E.B. Curing. Sita Technology LTD, 1999
- **A. VALET.** Lichtschutzmittel für Lacke. Vincentz Verlag Hannover, 1996, 33ff
- **A. VALET.** Lichtschutzmittel für Lacke. Vincentz Verlag Hannover, 1996, 20ff